(19) Europäisches Patentamt
European Patent Office
Office européen des brevets

(11) EP 4 674 926 A1

(12) EUROPEAN PATENT APPLICATION
published in accordance with Art. 153(4) EPC

(43) Date of publication:
**07.01.2026 Bulletin 2026/02**

(21) Application number: **24764086.5**

(22) Date of filing: **18.01.2024**

(51) International Patent Classification (IPC):
***C09K 11/62*** (2006.01) ***C09K 11/88*** (2006.01)
***H10K 50/115*** (2023.01) ***H01L 33/50*** (2010.01)

(52) Cooperative Patent Classification (CPC):
**C09K 11/621; C09K 11/02; C09K 11/623; C09K 11/88; C09K 11/883; H10K 50/115;**
B82Y 20/00; B82Y 40/00

(86) International application number:
**PCT/KR2024/000918**

(87) International publication number:
**WO 2024/181686 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.02.2023 KR 20230026905**

(71) Applicant: **Samsung Display Co., Ltd.**
**Yongin-si, Gyeonggi-do 17113 (KR)**

(72) Inventors:
- **YOON, Bit Na**
  **Yongin-si Gyeonggi-do 17113 (KR)**
- **KIM, Sung Jae**
  **Yongin-si Gyeonggi-do 17113 (KR)**
- **KIM, Young Sik**
  **Yongin-si Gyeonggi-do 17113 (KR)**
- **PARK, Seung Won**
  **Yongin-si Gyeonggi-do 17113 (KR)**
- **LEE, Dong Hee**
  **Yongin-si Gyeonggi-do 17113 (KR)**
- **JUNG, June Hyuk**
  **Yongin-si Gyeonggi-do 17113 (KR)**

(74) Representative: **Marks & Clerk LLP**
**15 Fetter Lane**
**London EC4A 1BW (GB)**

# (54) QUANTUM DOT, METHOD FOR MANUFACTURING SAME, AND LIGHT-EMITTING DEVICE, OPTICAL MEMBER, AND APPARATUS COMPRISING SAME

(57) A quantum dot having a narrow full width at half maximum, a manufacturing method thereof, and a light-emitting device, an optical member, and an apparatus including the quantum dot are provided.

FIG. 1

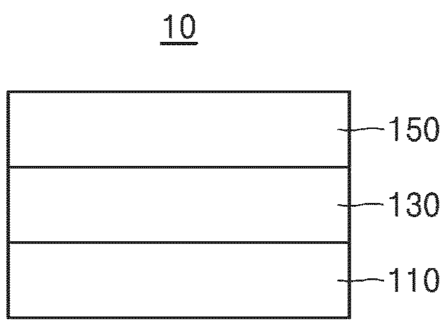


EP 4 674 926 A1

# Description

## Technical Field

The present disclosure relates to quantum dots, a manufacturing method thereof, and a light-emitting device, an optical member, and an apparatus including the quantum dots.

## Background Art

Quantum dots are nanocrystals of semiconductor materials and exhibit a quantum confinement effect. When quantum dots reach an energy excited state by receiving light from an excitation source, they emit energy according to a corresponding energy band gap by themselves. In this regard, even in substantially the same material, the wavelength varies depending on the particle sizes, and accordingly, by adjusting the sizes of quantum dots, light having the desired or suitable wavelength range may be obtained, and excellent or suitable color purity and high luminescence efficiency may be obtained. Thus, quantum dots are applicable to one or more suitable devices.

Additionally, quantum dots can be utilized as materials that perform one or more suitable optical functions (for example, a photo-conversion function) in optical members. Quantum dots, as nano-sized semiconductor nanocrystals, may have different energy band gaps by adjusting the size and composition of the nanocrystals, and thus may be to emit light of one or more suitable emission wavelengths.

An optical member including such quantum dots may have the form of a thin film, for example, a thin film patterned for each subpixel. Such an optical member may be utilized as a color conversion member of a device including one or more suitable light sources.

Difficulties associated with maintaining the uniformity of a crystal structure can create a distortion of energy levels due to surface defects, and light may be generated due to a recombination of a donor-acceptor pair (DAP). In addition, a full width at half maximum of quantum dots including a typical multi-component compound may be broad or wide.

## Disclosure of Invention

## Technical Problem

An object of the present disclosure is to provide a quantum dot having a narrow full width at half maximum, a manufacturing method thereof, and a light-emitting device, an optical member, and an apparatus including the quantum dot.

## Solution to Problem

According to one aspect, a quantum dot includes
a core including a Group I-III-VI compound and a shell covering the core, wherein the shell may include a Group II-VI compound or a Group III-VI compound, and, regarding the core and the shell, the molar ratio of a Group III element in the core to the Group III element in the shell may be from about 0.2 to about 0.6.

According to another aspect, a method of manufacturing a quantum dot includes forming a first mixture including a first material containing a Group I element, a second material containing a Group III element, a third material containing a Group III element, and a first ligand precursor,

forming a second mixture by mixing the first mixture and a fourth material containing a Group VI element,
forming a third mixture including a core from the second mixture,
forming a fourth mixture by mixing the third mixture and a second ligand precursor,
forming a fifth mixture by adding a fifth material containing a Group IV element and a sixth material containing a Group III element to the fourth mixture or by adding a fifth material containing a Group IV element and a seventh material containing a Group II element to the fourth mixture, and
forming a sixth mixture including the quantum dot including the core and the shell from the fifth mixture.

According to another aspect, a light-emitting device includes a first electrode, a second electrode facing the first electrode, and an emission layer between the first electrode and the second electrode, wherein the emission layer includes the quantum dot.

According to another aspect, an optical member includes the quantum dot.

According to another aspect, an apparatus includes the quantum dot.

Advantageous Effects of Invention

An energy level of a quantum dot may be precisely controlled or selected through a manufacturing method disclosed herein, and efficiency of a device, an optical member, and an apparatus that include the quantum dot may be improved.

## Brief Description of Drawings

FIG. 1 is a schematic drawing of a light-emitting device according to an embodiment of the present disclosure;
FIGS. 2 and 3 are schematic cross-sectional views of a light-emitting apparatus according to an embodiment of the present disclosure.

## Best Mode for Carrying out the Invention

Because the disclosure may have diverse modified embodiments, embodiments are illustrated in the drawings and are described in the detailed description. An effect and a characteristic of the disclosure, and a method of accomplishing these will be apparent when referring to embodiments described with reference to the drawings. The disclosure may, however, be embodied in many different forms and should not be construed as limited to the embodiments set forth herein.

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein. Accordingly, the embodiments are merely described, by referring to the drawings, to explain aspects of the present description.

It will be understood that although the terms "first," "second," etc. may be utilized herein to describe one or more suitable components, these components should not be limited by these terms. These components are only utilized to distinguish one component from another. Thus, a first element could be termed a second element without departing from the teachings of the present disclosure. Similarly, a second element could be termed a first element.

An expression utilized in the singular encompasses the expression of the plural, unless it has a clearly different meaning in the context.

It will be further understood that the terms "comprise," "comprises," "comprising," "include," "includes," "including," "have," "has," and/or "having," utilized herein specify the presence of stated features or elements, but do not preclude the presence or addition of one or more other features or elements.

In the following embodiments, when one or more suitable components such as layers, films, regions, plates, etc. are said to be "connected to," or "on" another component, this may include not only a case in which other components are "directly or immediately connected to" or "directly or immediately on" the layers, films, regions, or plates, but also a case in which other components may be placed therebetween. When an element is referred to as being "directly on," "directly connected to," or "directly coupled to" another element, there are no intervening elements present. In some embodiments, for convenience of description, components may be exaggerated or reduced in size in the drawings. Sizes of elements in the drawings may be exaggerated for convenience of explanation. In other words, because sizes and thicknesses of components in the drawings are arbitrarily illustrated for convenience of explanation, the following embodiments are not limited thereto.

Quantum dot

In an embodiment,

a quantum dot includes: a core including a Group I-III-VI compound; and a shell covering the core, wherein the shell includes a Group II-VI compound or a Group III-VI compound, and, regarding the core and the shell, the molar ratio of the Group III element in the core to the Group III element in the shell is from about 0.2 to about 0.6.

In a quantum dot according to an example embodiment, the Group I-III-VI compound may be represented by Formula 1:

Formula 1 $$M^1_aM^2_bM^3_cM^4_2$$

wherein, in Formula 1,

$M^1$ is a Group I metal element, $M^2$ and $M^3$ are each independently a Group III metal element, and $M^4$ is a Group VI

element,
a, b, and c are each independently 0 to 1, and
the sum of b and c is 0 to 1.

In the quantum dot according to an example embodiment, the sum of a, b, and c in Formula 1 may be 2.
In the quantum dot according to an example embodiment, $M^1$ in Formula 1 may be copper (Cu). For example, $M^1$ in Formula 1 may not be silver (Ag).
In the quantum dot according to an example embodiment, $M^2$ may be gallium (Ga), and $M^3$ may be indium (In).
In the quantum dot according to an example embodiment, $M^4$ may be oxygen (O) or sulfur (S), and may not be selenium (Se).
In the quantum dot according to an example embodiment, b/c in Formula 1 may be from 0.05 to 20. Additionally, because the quantum dot may generate light having a color close to green, b/c may be preferably from 0.1 to 10. Additionally, because the quantum dot may generate light having a full width at half maximum (FWHM) of about 140 nm or less, b/c may be preferably from 0.5 to 2. Additionally, because the quantum dot may generate light having a FWHM of about 60 nm or less and having green color, b/c may be most preferably from 1 to 1.5.
The quantum dot according to an example embodiment may
satisfy Condition (1) (Formula (1)):

$$0.5 < b/(b+c) < 0.9 \qquad (1)$$

wherein, when Formula (1) is satisfied, the FWHM of light emitted from the quantum dot may be about 140 nm or less, and the quantum dot may be to emit (e.g., configured to emit) light having a color close to green.
In the quantum dot according to an embodiment,
the Group II-VI compound may include at least one selected from among CdS, CdSe, CdTe, ZnS, ZnSe, ZnTe, ZnO, HgS, HgSe, and HgTe.
In the quantum dot according to an example embodiment,
the Group II-VI compound may include ZnS.
In the quantum dot according to an example embodiment,
the Group III-VI compound may include at least one selected from among $In_2S_3$, $In_2Se_3$, $Ga_2S_3$, $Ga_2Se_3$, $InGaS_3$, and $InGaSe_3$.
In the quantum dot according to an example embodiment, the Group III-VI compound may include $GaS_2$.
In the quantum dot according to an example embodiment, with respect to a sum of the Group I element and the Group III element included in the core, a molar ratio of the Group II element or the Group III element included in the shell may be from 1 to 10.
In the quantum dot according to an example embodiment, an average diameter ($d_{50}$) of the core may be from about 2 nm to about 10 nm.
An average diameter ($d_{50}$) of the quantum dot according to an example embodiment may be from about 3 nm to about 20 nm.
In the quantum dot according to an example embodiment, the FWHM of a photoluminescence peak of the quantum dot may be about 140 nm or less. Additionally, the FWHM of the photoluminescence peak may be about 60 nm or less. Accordingly, the color gamut (e.g., color range) of the quantum dot may be enhanced or improved.
The quantum dot according to an example embodiment may emit blue light or green light.
The quantum dot according to an example embodiment may have a maximum emission wavelength ($\lambda_{max}$) of about 480 nm to about 530 nm.
The quantum dot according to an example embodiment may absorb blue light.
The core and shell may have a structure with reduced lattice mismatch due to the composition of the shell forming a concentration gradient. Therefore, generation of defects in an interface between the core and the shell may be reduced, the core of the quantum dot may be protected utilizing a shell with sufficient thickness, and, at the same time, high light efficiency and high color purity may be implemented.
In an example embodiment, the shape of the quantum dot is not specifically limited, and may be any one commonly utilized in the art.
For example, the quantum dot may be in the form of a spherical particle, a pyramidal particle, a multi-arm particle, a cubic nanoparticle, a nanotube particle, a nanowire particle, a nanofiber particle, and/or a nanoplate particle.
The term "quantum dots" as utilized herein refers to crystals of a semiconductor compound, and may include any material capable of emitting light of one or more suitable emission wavelengths according to the size of the crystals.
In the quantum dot according to an example embodiment, the average thickness of the shell may be less than the

core.

In the quantum dot according to an example embodiment, the average thickness of the shell may be from about 1 nm to about 4 nm. For example, the average thickness of the shell may be from about 1 nm to about 2 nm.

Method of manufacturing a quantum dot

In another embodiment,

a method of manufacturing a quantum dot includes: forming a first mixture including a first material containing a Group I element, a second material containing a Group III element, a third material containing a Group III element, and a first ligand precursor;
forming a second mixture by mixing the first mixture and a fourth material containing a Group VI element;
forming a third mixture including a core from the second mixture;
forming a fourth mixture by mixing the third mixture and a second ligand precursor;
forming a fifth mixture by adding a fifth material containing a Group IV element and a sixth material containing a Group III element to the fourth mixture or by adding a fifth material containing a Group IV element and a seventh material containing a Group II element to the fourth mixture, and
forming a sixth mixture including the quantum dot including the core and the shell from the fifth mixture.

In the manufacturing method of the quantum dot according to an example embodiment, the first material may include copper (Cu).

In the manufacturing method of the quantum dot, one or more of Conditions i) to iii) may be satisfied. For example, Conditions i) to iii) may all be satisfied.

i) The second material and the sixth material may each include gallium (Ga)

ii) The third material may include indium (In)

iii) The fourth material and the fifth material may each include sulfur (S).

In the manufacturing method of the quantum dot according to an example embodiment, the fourth material may include a sulfur atom (atomic S) and a thiol-based compound. The ratio of the number of moles of the thiol-based compound with respect to the number of moles of the sulfur atoms may be from about 1 to about 4. The ratio of the number of moles of the thiol-based compound with respect to the number of moles of the sulfur atoms may be from about 1.5 to about 3 in terms that a substantially uniform core may be formed.

In the manufacturing method of the quantum dot according to an example embodiment, the thiol-based compound may include one or more of $C_1$-$C_{60}$ alkyl thiol and $C_3$-$C_{60}$ cycloalkyl thiol. For example, $C_1$-$C_{60}$ alkyl thiol may include linear alkyl thiol and branched alkyl thiol. For example, n-decanethiol, n-undecanethiol, and n-dodecanethiol may be considered as linear alkyl thiol.

In the manufacturing method of the quantum dot, one or more of Conditions iv) and v) may be satisfied. For example, Conditions iv) and v) may both be satisfied.

iv) The first ligand precursor may include at least one of a primary amine, a secondary amine, a tertiary amine, and/or a phosphine oxide.

v) the second ligand precursor may include a primary amine.

Additionally, the primary amine may be represented by $RNH_2$, the secondary amine may be represented by $R_2NH$, and the tertiary amine may be represented by $R_3N$. Additionally, the phosphine oxide may be represented by $R_2HPO$. Here, R(s) may be identical to or different from each other, and may each independently be a substituted or unsubstituted $C_1$-$C_{40}$ aliphatic hydrocarbon (e.g., a $C_1$-$C_{40}$ alkyl group, a $C_2$-$C_{40}$ alkenyl group, and/or a $C_2$-$C_{40}$ alkynyl group).

Additionally, the first ligand precursor may include one or more primary amines. Similarly, the first ligand precursor may include one or more secondary amines or one or more tertiary amines.

Additionally, the first ligand precursor may dissolve the sulfur atoms included in the fourth material, and the sulfur atoms may be included in the second mixture in a stable state by the first ligand precursor.

In the manufacturing method of the quantum dot according to an example embodiment, the forming of the third mixture and the forming of the sixth mixture may each independently be performed at about 240 °C to about 300 °C.

Additionally, in the manufacturing method of the quantum dot according to an example embodiment, stopping or cooling each compound may further be included before or after each step.

In the manufacturing method of quantum dots according to an example embodiment, the type or kind of charge of the first ligand and/or the type or kind of formal charge of the second ligand may be independent, negative or neutral independently.

In the manufacturing method of the quantum dot according to an example embodiment, a ligand derived from a first ligand precursor and a ligand derived from the second ligand precursor may each independently include one or more

electron-donating groups, wherein the shared electron pairs or unshared electron pairs of the ligand may be shared or coordinated in the shell.

In the manufacturing method of the quantum dot according to an example embodiment, the ligand derived from the first ligand precursor and the ligand derived from the second ligand precursor may each independently change the size of the dipole momentum of the core or the shell.

Additionally, the quantum dots may be synthesized by a wet chemical process, an organic metal chemical vapor deposition process, a molecular beam epitaxy process, and/or any similar process.

The wet chemical process is a method including mixing a precursor material with an organic solvent and then growing a quantum dot particle crystal. When the crystal grows, the organic solvent naturally acts as a dispersant coordinated on the surface of the quantum dot crystal and controls the growth of the crystal so that the growth of quantum dot particles can be controlled or selected through a process which costs less, and is easier than vapor deposition methods, such as metal organic chemical vapor deposition (MOCVD) or molecular beam epitaxy (MBE).

Because the energy band gap may be adjusted according to the adjustment of the size of the quantum dots or the element ratio within the quantum dot, light of one or more suitable wavelengths may be obtained in the quantum dot emission layer. Therefore, by utilizing the quantum dot as described herein (utilizing quantum dots of different sizes or with different element ratios), a light-emitting device emitting light of one or more suitable wavelengths may be implemented. For example, red, green, and/or blue light may be selectively emitted by controlling the size of the quantum dot or the element ratio in the quantum dots, and, for example, green light may be emitted by controlling the size of the quantum dots. Additionally, the size of the quantum dot and the element ratio in the quantum dots may be configured to emit white light by combination of light of one or more suitable colors.

In the quantum dots according to an example embodiment, the core may include relatively inexpensive copper (Cu) and excludes relatively expensive silver (Ag). As a result, the cost of production of quantum dots may be significantly reduced.

Because the core includes a Group I-III-VI compound, a quantum confinement effect by the core may be limited. As a result, the absorbance of blue light of the quantum dots including the core may be improved, and the color conversion efficiency of a color conversion member including the quantum dots may be improved.

The quantum dots according to an example embodiment may include a shell covering the core, and the shell may limit the increase of the FWHM due to a surface defect of the core. As a result, the FWHM of light emitted from the quantum dots including the shell may be reduced.

In particular, the quantum dots including the core and shell may have a narrow full width at half maximum (FWHM) of the emission wavelength spectrum. For example, the FWHM may be about 140 nm or less. For example, the FWHM may be about 90 nm or less. For example, the FWHM may be about 60 nm or less. Accordingly, the color purity and color gamut of light emitted from the quantum dots may be improved.

In addition, the efficiency and lifespan of the device, the optical member, and the apparatus to which the quantum dots are applied may be improved.

Light-emitting device

FIG. 1 is a schematic cross-sectional view of a light-emitting device 30 according to an embodiment. The light-emitting device 30 may include a first electrode 110, an interlayer 130, and a second electrode 150.

Hereinafter, a structure of the light-emitting device 30 according to an embodiment and a method of manufacturing the light-emitting device 30 will be described in connection with FIG. 1.

The interlayer or the emission layer may include the quantum dots.

First electrode 110

In FIG. 1, a substrate may be additionally located under the first electrode 110 or on the second electrode 150. As the substrate, a glass substrate or a plastic substrate may be utilized. Alternatively, the substrate may be a flexible substrate, and may include plastics with excellent or suitable heat resistance and durability, such as polyimide, polyethylene terephthalate (PET), polycarbonate, polyethylene naphthalate, polyarylate (PAR), polyetherimide, or a combination thereof.

The first electrode 110 may be formed by, for example, depositing or sputtering a material for forming the first electrode 110 on the substrate. When the first electrode 110 is an anode, a material for forming the first electrode 110 may be a high-work function material that facilitates injection of holes.

The first electrode 110 may be a reflective electrode, a semi-transmissive electrode, or a transmissive electrode. When the first electrode 110 is a transmissive electrode, a material for forming the first electrode 110 may include indium tin oxide (ITO), indium zinc oxide (IZO), tin oxide ($SnO_2$), zinc oxide (ZnO), or a combination thereof. Alternatively, when the first electrode 110 is a semi-transmissive electrode or a reflective electrode, a material for forming the first electrode 110

may include magnesium (Mg), silver (Ag), aluminium (Al), aluminium-lithium (Al-Li), calcium (Ca), magnesium-indium (Mg-In), magnesium-silver (Mg-Ag), or a combination thereof.

The first electrode 110 may have a single-layered structure consisting of a single layer or a multi-layered structure including a plurality of layers. For example, the first electrode 110 may have a three-layered structure of ITO/Ag/ITO.

Interlayer 130

The interlayer 130 may be located on the first electrode 110. The interlayer 130 may include an emission layer.

The interlayer 130 may further include a hole transport region located between the first electrode 110 and the emission layer, and an electron transport region located between the emission layer and the second electrode 150.

For example, the interlayer 130 may include the quantum dots according to an example embodiment. The quantum dots may each independently be the same as described herein.

The interlayer 130 may further include metal-containing compounds such as organometallic compounds, in addition to one or more suitable organic materials and quantum dots.

Meanwhile, the interlayer 130 may include, i) two or more emitting units sequentially stacked between the first electrode 110 and the second electrode 150, and ii) a charge generation layer located between the two or more emitting units. When the interlayer 130 includes the emitting units and the charge generation layer as described herein, the light-emitting device 30 may be a tandem light-emitting device.

Hole transport region in interlayer 130

The hole transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The hole transport region may include a hole injection layer, a hole transport layer, an emission auxiliary layer, an electron-blocking layer, or a combination thereof.

For example, the hole transport region may have a multi-layered structure including a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron-blocking layer structure, the layers of each structure being stacked sequentially from the first electrode 110.

The hole transport region may include a compound represented by Formula 201, a compound represented by Formula 202, or a combination thereof:

Formula 201

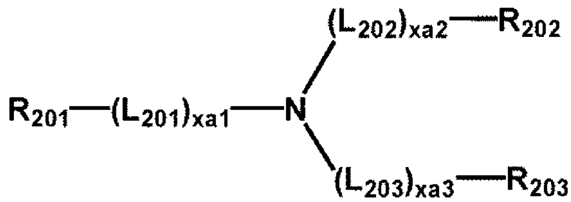

Formula 202

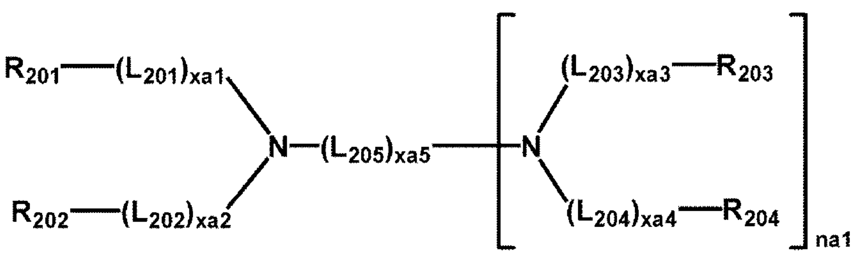

wherein, in Formulae 201 and 202,

$L_{201}$ to $L_{204}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

$L_{205}$ may be *-O-*', *-S-*', *-N($Q_{201}$)-*', a $C_1$-$C_{20}$ alkylene group unsubstituted or substituted with at least one $R_{10a}$, a $C_2$-$C_{20}$ alkenylene group unsubstituted or substituted with at least one $R_{10a}$, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

xa1 to xa4 may each independently be an integer from 0 to 5,

xa5 may be an integer from 1 to 10,

$R_{201}$ to $R_{204}$ and $Q_{201}$ may each independently be a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$,

$R_{201}$ and $R_{202}$ may optionally be linked to each other via a single bond, a $C_1$-$C_3$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group (for example, a carbazole group and/or the like) unsubstituted or substituted with at least one $R_{10a}$ (for example, Compound HT16),

$R_{203}$ and $R_{204}$ may optionally be linked to each other via a single bond, a $C_1$-$C_5$ alkylene group unsubstituted or substituted with at least one $R_{10a}$, or a $C_2$-$C_5$ alkenylene group unsubstituted or substituted with at least one $R_{10a}$, to form a $C_8$-$C_{60}$ polycyclic group unsubstituted or substituted with at least one $R_{10a}$, and

na1 may be an integer from 1 to 4.

For example, each of Formulae 201 and 202 may include at least one of groups represented by Formulae CY201 to CY217:

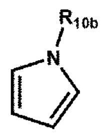
CY201
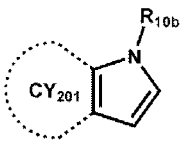
CY202
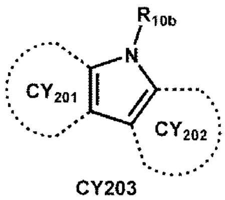
CY203
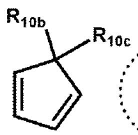
CY204
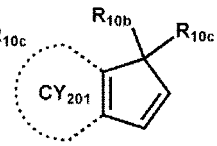
CY205
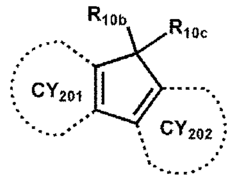
CY206

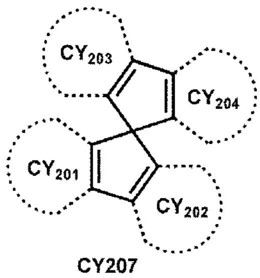
CY207
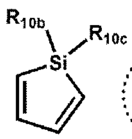
CY208
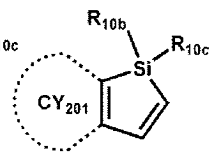
CY209
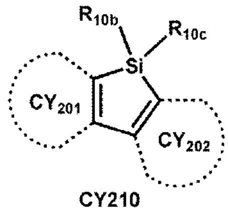
CY210
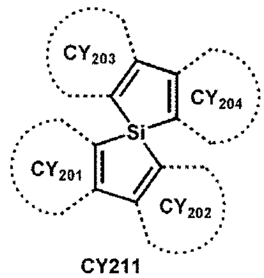
CY211

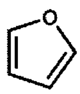
CY212
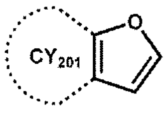
CY213
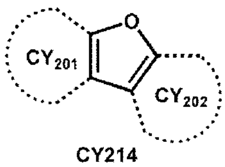
CY214
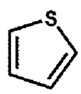
CY215
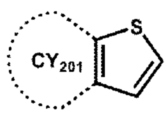
CY216
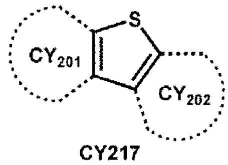
CY217

.

In Formulae CY201 to CY217, $R_{10b}$ and $R_{10c}$ may each be the same as described with respect to $R_{10a}$, ring $CY_{201}$ to ring $CY_{204}$ may each independently be a $C_3$-$C_{20}$ carbocyclic group or a $C_1$-$C_{20}$ heterocyclic group, and at least one hydrogen in Formulae CY201 to CY217 may be unsubstituted or substituted with $R_{10a}$ as described herein.

In one or embodiments, ring $CY_{201}$ to ring $CY_{204}$ in Formulae CY201 to CY217 may each independently be a benzene group, a naphthalene group, a phenanthrene group, or an anthracene group.

In one or more embodiments, each of Formulae 201 and 202 may include at least one of groups represented by Formulae CY201 to CY203.

In one or more embodiments, Formula 201 may include at least one of the groups represented by Formulae CY201 to CY203 and at least one of the groups represented by Formulae CY204 to CY217.

In one or more embodiments, in Formula 201, xa1 may be 1, $R_{201}$ may be a group represented by one of Formulae CY201 to CY203, xa2 may be 0, and $R_{202}$ may be a group represented by one of Formulae CY204 to CY207.

In one or more embodiments, each of Formulae 201 and 202 may not include a group represented by one of

Formulae CY201 to CY203.

In one or more embodiments, each of Formulae 201 and 202 may not include a group represented by one of Formulae CY201 to CY203, and may include at least one of the groups represented by Formulae CY204 to CY217.

In one or more embodiments, each of Formulae 201 and 202 may not include a group represented by one of Formulae CY201 to CY217.

For example, the hole transport region may include at least one selected from among Compounds HT1 to HT46, m-MTDATA, TDATA, 2-TNATA, NPB(NPD), β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), and/or a combination thereof:

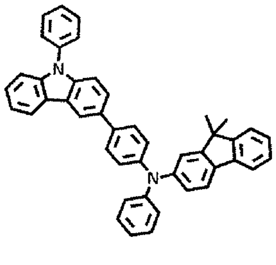
HT1

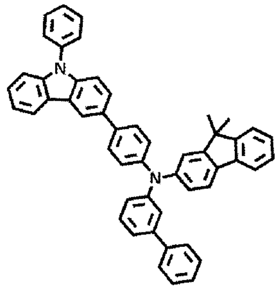
HT2

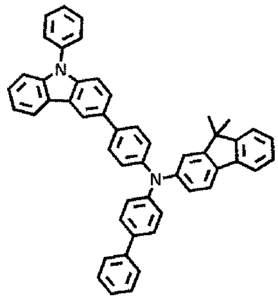
HT3

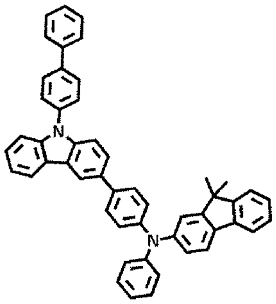
HT4

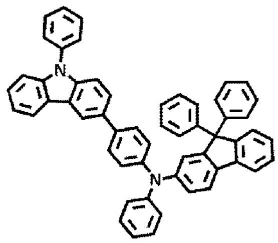
HT5

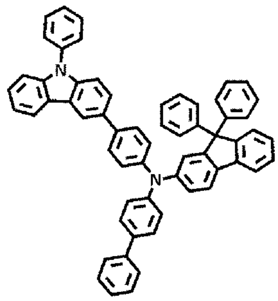
HT6

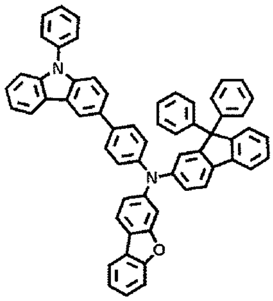
HT7

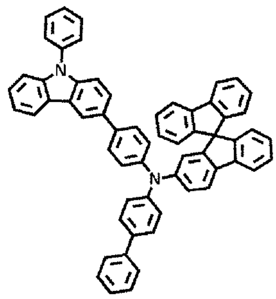
HT8

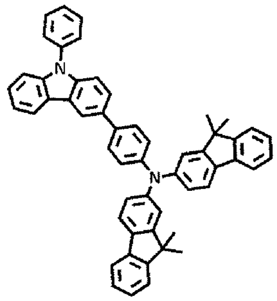
HT9

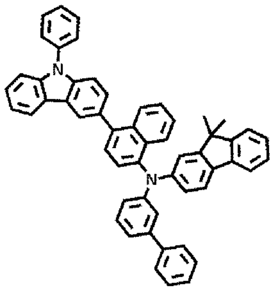
HT10

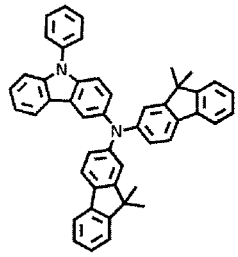
HT11

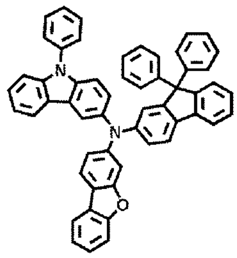
HT12

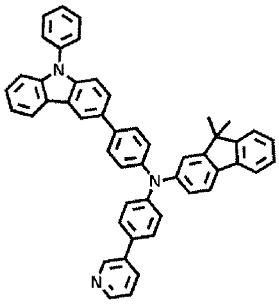
HT13

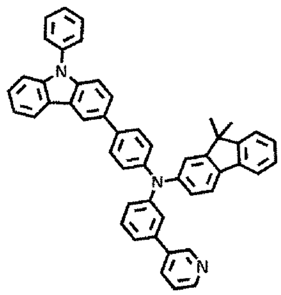
HT14

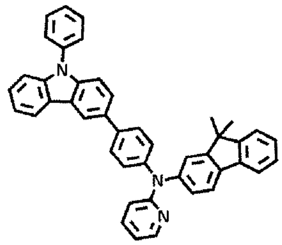
HT15

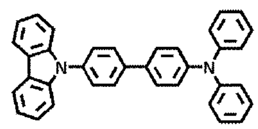
HT16

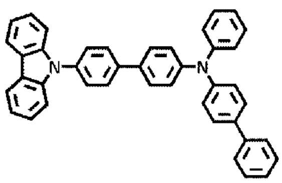
HT17

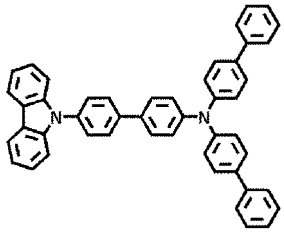
HT18

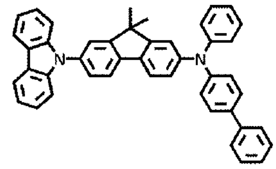
HT19

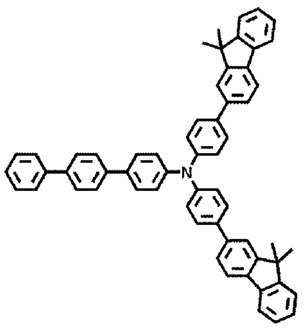
HT20

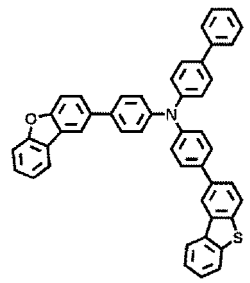
HT21

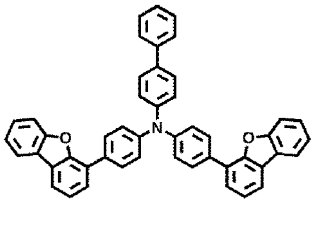
HT22

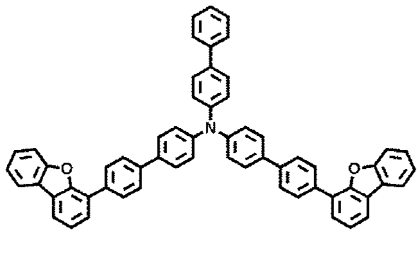
HT23

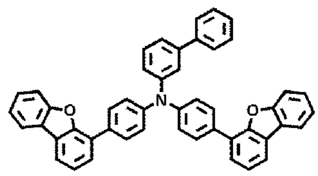
HT24

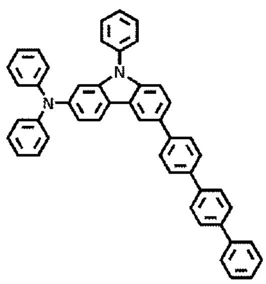
HT25

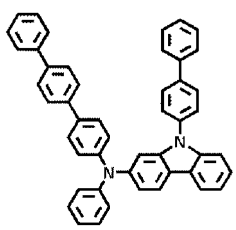
HT26

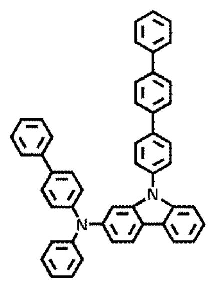
HT27

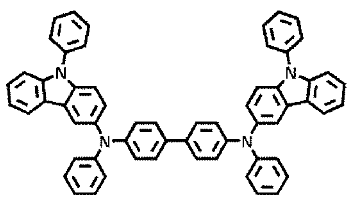

HT28

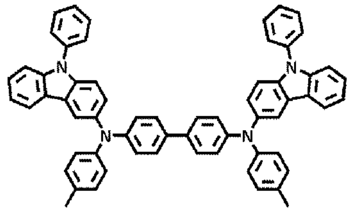

HT29

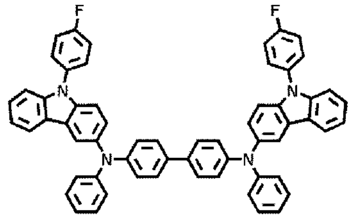

HT30

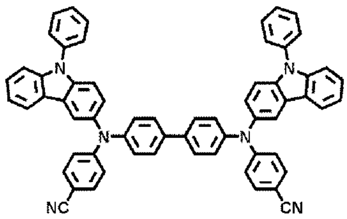

HT31

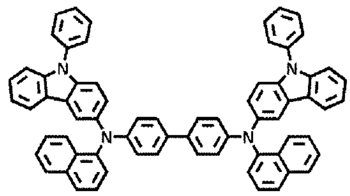

HT32

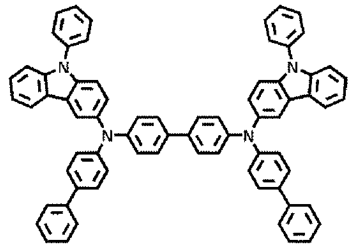

HT33

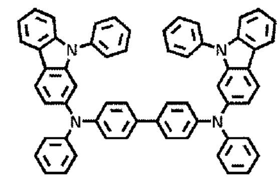

HT34

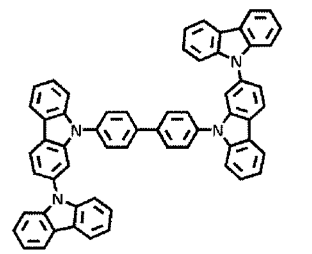

HT35

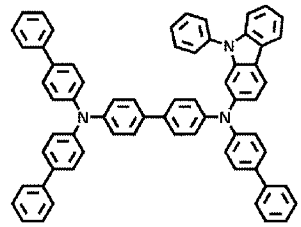

HT36

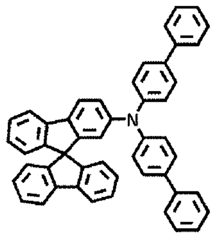

HT37

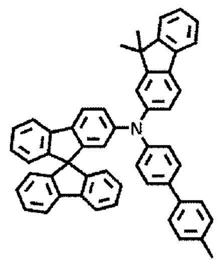

HT38

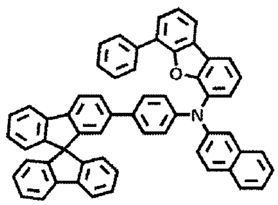

HT39

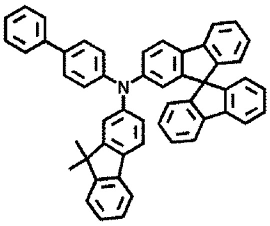

HT40

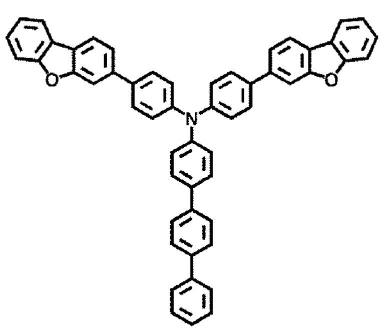

HT41

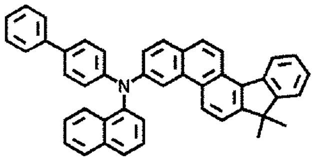

HT42

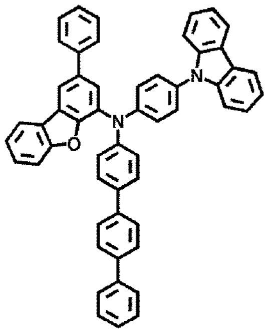

HT43

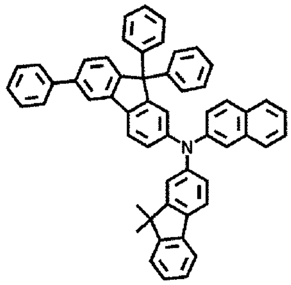

HT44

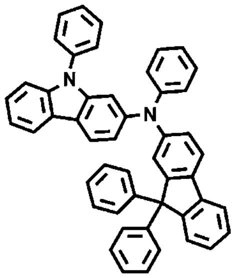

HT45

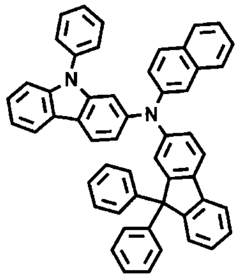

HT46

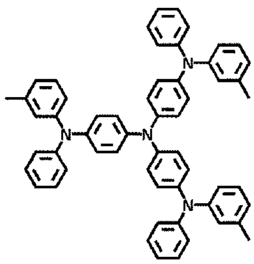

m-MTDATA

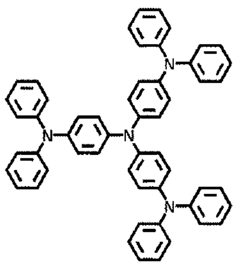

TDATA

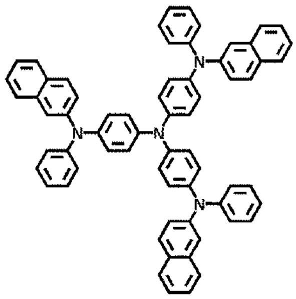

2-TNATA

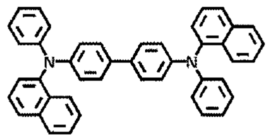

NPB

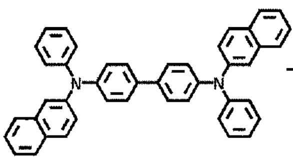

β-NPB

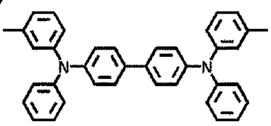

TPD

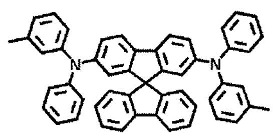

Spiro-TPD

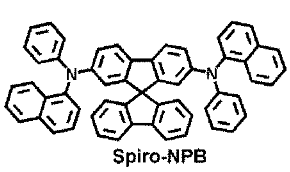

Spiro-NPB

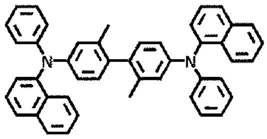

methylated-NPB

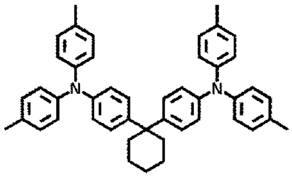

TAPC

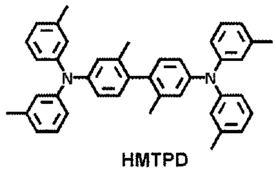

HMTPD

A thickness of the hole transport region may be in a range of about 50 angstrom (Å) to about 10,000 Å, for example, about 100 Å to about 4,000 Å. When the hole transport region includes a hole injection layer, a hole transport layer, or a combination thereof, a thickness of the hole injection layer may be in a range of about 100 Å to about 9,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection

layer, and the hole transport layer are within these ranges, satisfactory hole transporting characteristics may be obtained without a substantial increase in driving voltage.

The emission auxiliary layer may increase light-emission efficiency by compensating for an optical resonance distance according to the wavelength of light emitted by an emission layer, and the electron-blocking layer may block or reduce the leakage of electrons from an emission layer to a hole transport region. Materials that may be included in the hole transport region may be included in the emission auxiliary layer and the electron-blocking layer.

p-dopant

The hole transport region may further include, in addition to these materials, a charge-generation material for the improvement of conductive properties. The charge-generation material may be uniformly or non-uniformly dispersed in the hole transport region (for example, in the form of a single layer consisting of a charge-generation material).

The charge-generation material may be, for example, a p-dopant.

For example, the lowest unoccupied molecular orbital (LUMO) energy level of the p-dopant may be -3.5 electron volt (eV) or less.

In an embodiment, the p-dopant may include a quinone derivative, a cyano group-containing compound, a compound including element EL1 and element EL2, or a combination thereof.

Examples of the quinone derivative are TCNQ, F4-TCNQ, and/or the like.

Examples of the cyano group-containing compound are HAT-CN and a compound represented by Formula 221:

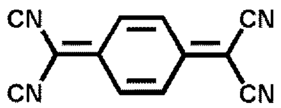

**TCNQ**

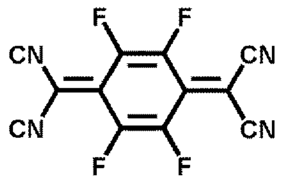

**F4-TCNQ**

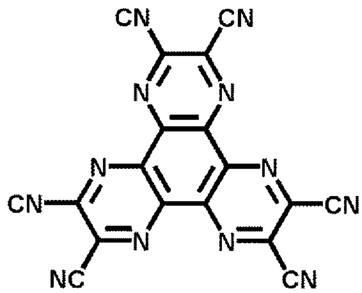

**HAT-CN**

Formula 221

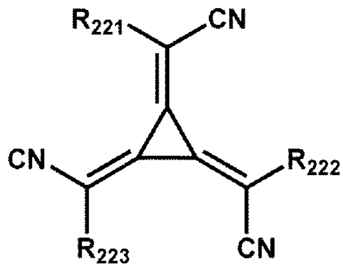

.

In Formula 221,

$R_{221}$ to $R_{223}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$, and
at least one selected from among $R_{221}$ to $R_{223}$ may each independently be a $C_3$-$C_{60}$ carbocyclic group or a $C_1$-$C_{60}$ heterocyclic group, each substituted with a cyano group; -F; -Cl; -Br; -I; a $C_1$-$C_{20}$ alkyl group substituted with a cyano group, -F, -Cl, -Br, - I, or a combination thereof; or a combination thereof.

In the compound including element EL1 and element EL2, element EL1 may be metal, metalloid, or a combination thereof, and element EL2 may be non-metal, metalloid, or a combination thereof.

Examples of the metal are an alkali metal (for example, lithium (Li), sodium (Na), potassium (K), rubidium (Rb), cesium (Cs), etc.); alkaline earth metal (for example, beryllium (Be), magnesium (Mg), calcium (Ca), strontium (Sr), barium (Ba), and/or the like); transition metal (for example, titanium (Ti), zirconium (Zr), hafnium (Hf), vanadium (V), niobium (Nb), tantalum (Ta), chromium (Cr), molybdenum (Mo), tungsten (W), manganese (Mn), technetium (Tc), rhenium (Re), iron

(Fe), ruthenium (Ru), osmium (Os), cobalt (Co), rhodium (Rh), iridium (Ir), nickel (Ni), palladium (Pd), platinum (Pt), copper (Cu), silver (Ag), gold (Au), and/or the like); post-transition metal (for example, zinc (Zn), indium (In), tin (Sn), and/or the like); and lanthanide metal (for example, lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), and/or the like).

Examples of the metalloid are silicon (Si), antimony (Sb), and tellurium (Te).

Examples of the non-metal are oxygen (O) and halogen (for example, F, Cl, Br, I, and/or the like).

Examples of the compound including element EL1 and element EL2 are metal oxide, metal halide (for example, metal fluoride, metal chloride, metal bromide, or metal iodide), metalloid halide (for example, metalloid fluoride, metalloid chloride, metalloid bromide, or metalloid iodide), metal telluride, or a combination thereof.

Examples of the metal oxide are tungsten oxide (for example, WO, $W_2O_3$, $WO_2$, $WO_3$, $W_2O_3$, and/or the like), vanadium oxide (for example, VO, $V_2O_3$, $VO_2$, $V_2O_5$, and/or the like), molybdenum oxide (MoO, $Mo_2O_3$, $MoO_2$, $MoO_3$, $Mo_2O_5$, and/or the like), and rhenium oxide (for example, $ReO_3$, and/or the like).

Examples of the metal halide are alkali metal halide, alkaline earth metal halide, transition metal halide, post-transition metal halide, and lanthanide metal halide.

Examples of the alkali metal halogen may include LiF, NaF, KF, RbF, CsF, LiCl, NaCl, KCl, RbCl, CsCl, LiBr, NaBr, KBr, RbBr, CsBr, LiI, NaI, KI, RbI, and CsI.

Examples of the alkaline earth metal halide are $BeF_2$, $MgF_2$, $CaF_2$, $SrF_2$, $BaF_2$, $BeCl_2$, $MgCl_2$, $CaCl_2$, $SrCl_2$, $BaCl_2$, $BeBr_2$, $MgBr_2$, $CaBr_2$, $SrBr_2$, $BaBr_2$, $BeI_2$, $MgI_2$, $CaI_2$, $SrI_2$, and $BaI_2$.

Examples of the transition metal halide are titanium halide (for example, $TiF_4$, $TiCl_4$, $TiBr_4$, $TiI_4$, and/or the like), zirconium halide (for example, $ZrF_4$, $ZrCl_4$, $ZrBr_4$, $ZrI_4$, and/or the like), hafnium halide (for example, $HfF_4$, $HfCl_4$, $HfBr_4$, $HfI_4$, and/or the like), vanadium halide (for example, $VF_3$, $VCl_3$, $VBr_3$, $VI_3$, and/or the like), niobium halide (for example, $NbF_3$, $NbCl_3$, $NbBr_3$, $NbI_3$, and/or the like), tantalum halide (for example, $TaF_3$, $TaCl_3$, $TaBr_3$, $TaI_3$, and/or the like), chromium halide (for example, $CrF_3$, $CrCl_3$, $CrBr_3$, $CrI_3$, and/or the like), molybdenum halide (for example, $MoF_3$, $MoCl_3$, $MoBr_3$, $MoI_3$, and/or the like), tungsten halide (for example, $WF_3$, $WCl_3$, $WBr_3$, $WI_3$, and/or the like), manganese halide (for example, $MnF_2$, $MnCl_2$, $MnBr_2$, $MnI_2$, and/or the like), technetium halide (for example, $TcF_2$, $TcCl_2$, $TcBr_2$, $TcI_2$, and/or the like), rhenium halide (for example, $ReF_2$, $ReCl_2$, $ReBr_2$, $ReI_2$, and/or the like), iron halide (for example, $FeF_2$, $FeCl_2$, $FeBr_2$, $FeI_2$, and/or the like), ruthenium halide (for example, $RuF_2$, $RuCl_2$, $RuBr_2$, $RuI_2$, and/or the like), osmium halide (for example, $OsF_2$, $OsCl_2$, $OsBr_2$, $OsI_2$, and/or the like), cobalt halide (for example, $CoF_2$, $CoCl_2$, $CoBr_2$, $CoI_2$, and/or the like), rhodium halide (for example, $RhF_2$, $RhCl_2$, $RhBr_2$, $RhI_2$, and/or the like), iridium halide (for example, $IrF_2$, $IrCl_2$, $IrBr_2$, $IrI_2$, and/or the like), nickel halide (for example, $NiF_2$, $NiCl_2$, $NiBr_2$, $NiI_2$, and/or the like), palladium halide (for example, $PdF_2$, $PdCl_2$, $PdBr_2$, $PdI_2$, and/or the like), platinum halide (for example, $PtF_2$, $PtCl_2$, $PtBr_2$, $PtI_2$, and/or the like), copper halide (for example, CuF, CuCl, CuBr, CuI, and/or the like), silver halide (for example, AgF, AgCl, AgBr, AgI, and/or the like), and gold halide (for example, AuF, AuCl, AuBr, AuI, and/or the like).

Examples of the post-transition metal halide are zinc halide (for example, $ZnF_2$, $ZnCl_2$, $ZnBr_2$, $ZnI_2$, and/or the like), indium halide (for example, $InI_3$, and/or the like), and tin halide (for example, $SnI_2$, and/or the like).

Examples of the lanthanide metal halide are YbF, $YbF_2$, $YbF_3$, $SmF_3$, YbCl, $YbCl_2$, $YbCl_3$ $SmCl_3$, YbBr, $YbBr_2$, $YbBr_3$ $SmBr_3$, YbI, $YbI_2$, $YbI_3$, and $SmI_3$.

An example of the metalloid halide is antimony halide (for example, $SbCl_5$, and/or the like).

Examples of the metal telluride are alkali metal telluride (for example, $Li_2Te$, $Na_2Te$, $K_2Te$, $Rb_2Te$, $Cs_2Te$, and/or the like), alkaline earth metal telluride (for example, BeTe, MgTe, CaTe, SrTe, BaTe, and/or the like), transition metal telluride (for example, $TiTe_2$, $ZrTe_2$, $HfTe_2$, $V_2Te_3$, $Nb_2Te_3$, $Ta_2Te_3$, $Cr_2Te_3$, $Mo_2Te_3$, $W_2Te_3$, MnTe, TcTe, ReTe, FeTe, RuTe, OsTe, CoTe, RhTe, IrTe, NiTe, PdTe, PtTe, $Cu_2Te$, CuTe, $Ag_2Te$, AgTe, $Au_2Te$, and/or the like), post-transition metal telluride (for example, ZnTe, and/or the like), and lanthanide metal telluride (for example, LaTe, CeTe, PrTe, NdTe, PmTe, EuTe, GdTe, TbTe, DyTe, HoTe, ErTe, TmTe, YbTe, LuTe, and/or the like).

Emission layer in interlayer 130

When the light-emitting device 30 is a full-color light-emitting device, according to a subpixel, the emission layer may be patterned into a red emission layer, a green emission layer, and/or a blue emission layer. Alternatively, the emission layer may have a stacked structure of two or more layers of a red emission layer, a green emission layer, and a blue emission layer, in which the two or more layers contact each other or are separated from each other to emit white light, or the emission layer may include two or more materials of a red light-emitting material, a green light-emitting material, and a blue light-emitting material, in which the two or more materials are mixed with each other in a single layer to emit white light.

The emission layer may include the quantum dot according to an example embodiment.

The emission layer may further include a host and a dopant in addition to the quantum dot. The dopant may include a phosphorescent dopant, a fluorescent dopant, or a combination thereof.

The amount of the dopant in the emission layer may be from about 0.01 parts by weight to about 15 parts by weight

based on 100 parts by weight of the host.

Meanwhile, the emission layer may include a delayed fluorescence material. The delayed fluorescence material may act as a host or a dopant in the emission layer.

A thickness of the emission layer may be in a range of about 100 Å to about 1,000 Å, for example, about 200 Å to about 600 Å. When the thickness of the emission layer is within these ranges, excellent or suitable light-emission characteristics may be obtained without a substantial increase in driving voltage.

Host

The host may include a compound represented by Formula 301:

Formula 301 $[Ar301]_{xb11}-[(L301)_{xb1}-R301]_{xb21}$

In Formula 301,

$Ar_{301}$ and $L_{301}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
xb11 may be 1, 2, or 3,
xb1 may be an integer from 0 to 5,
$R_{301}$ may be hydrogen, deuterium, -F, -Cl, -Br, -I, a hydroxyl group, a cyano group, a nitro group, a $C_1$-$C_{60}$ alkyl group unsubstituted or substituted with at least one $R_{10a}$, a $C_2$-$C_{60}$ alkenyl group unsubstituted or substituted with at least one $R_{10a}$, a $C_2$-$C_{60}$ alkynyl group unsubstituted or substituted with at least one $R_{10a}$, a $C_1$-$C_{60}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$,$-Si(Q_{301})(Q_{302})(Q_{303})$, $-N(Q_{301})(Q_{302})$, $-B(Q_{301})(Q_{302})$, $-C(=O)(Q_{301})$, $-S(=O)_2(Q_{301})$, or $-P(=O)(Q_{301})(Q_{302})$,
xb21 may be an integer from 1 to 5, and
$Q_{301}$ to $Q_{303}$ are each the same as described herein with respect to $Q_1$.

For example, when xb11 in Formula 301 is 2 or more, two or more of $Ar_{301}$(s) may be linked to each other via a single bond.

As another example, the host may include a compound represented by Formula 301-1, a compound represented by Formula 301-2, or a combination thereof:

Formula 301-1

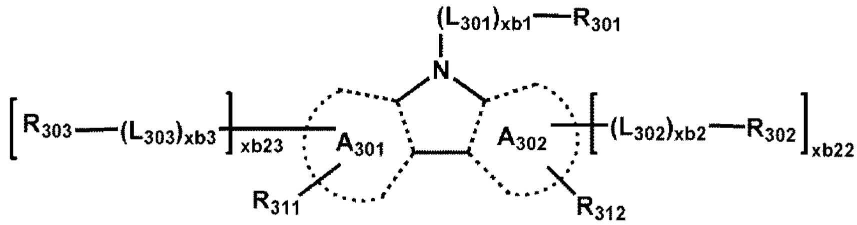

Formula 301-2

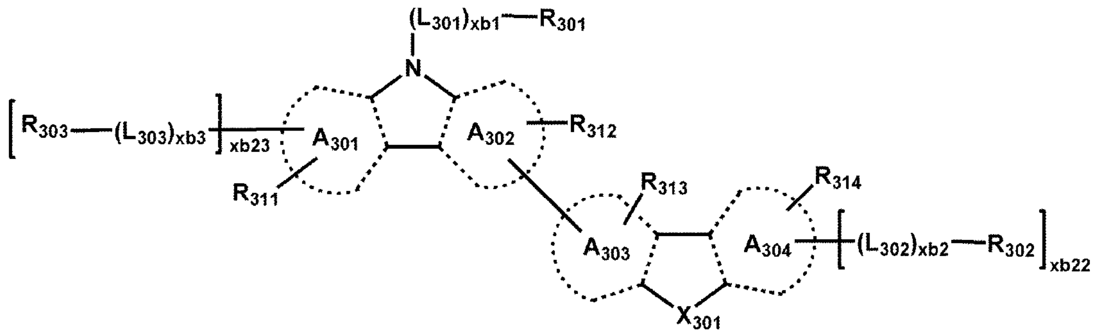

In Formulae 301-1 and 301-2,

ring $A_{301}$ to ring $A_{304}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
$X_{301}$ may be O, S, N-[$(L_{304})_{xb4}$-$R_{304}$], C($R_{304}$)($R_{305}$), or Si($R_{304}$)($R_{305}$),
xb22 and xb23 may each independently be 0, 1, or 2,
$L_{301}$, xb1, and $R_{301}$ may each be the same as described herein,
$L_{302}$ to $L_{304}$ may each independently be the same as described herein with respect to with $L_{301}$,
xb2 to xb4 may each independently be the same as described herein with respect to xb1, and
$R_{302}$ to $R_{303}$ and $R_{311}$ to $R_{314}$ may each be the same as described herein with respect to $R_{301}$.

As another example, the host may include an alkali earth metal complex, a post-transition metal complex, or a combination thereof. For example, the host may include a Be complex (for example, Compound H55), an Mg complex, a Zn complex, or a combination thereof.

As another example, the host may include at least one selected from among Compounds H1 to H124, 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and/or a combination thereof:

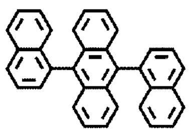
H1

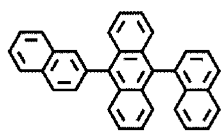
H2

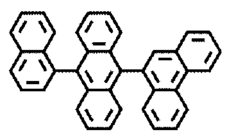
H3

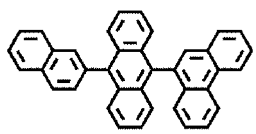
H4

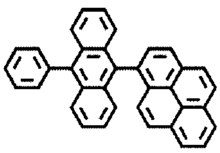
H5

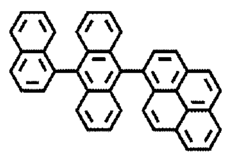
H6

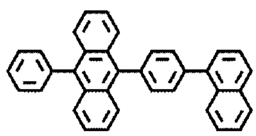
H7

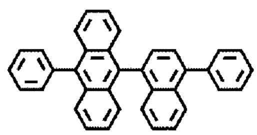
H8

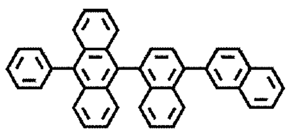
H9

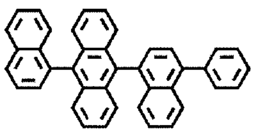
H10

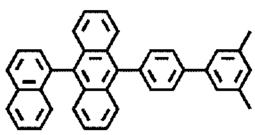
H11

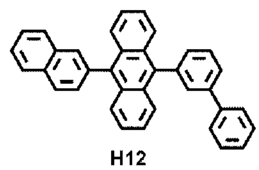
H12

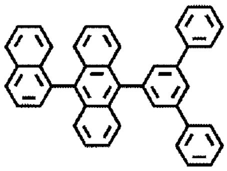

H13

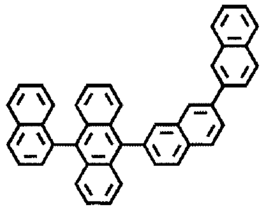

H14

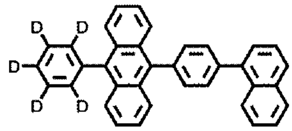

H15

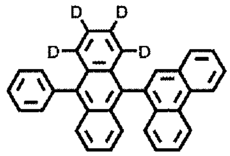

H16

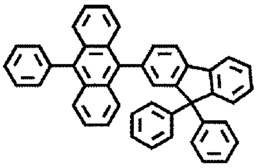

H17

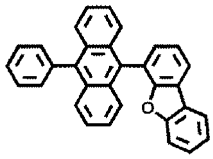

H18

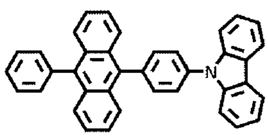

H19

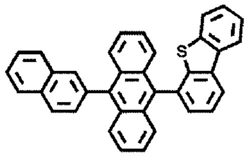

H20

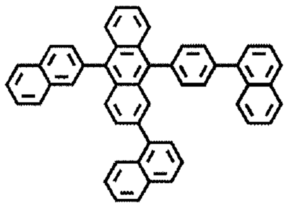

H21

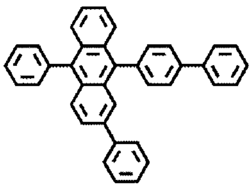

H22

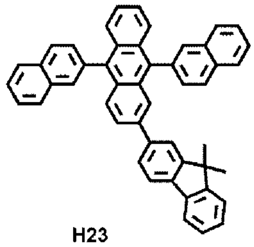

H23

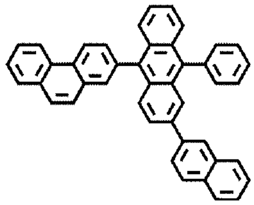

H24

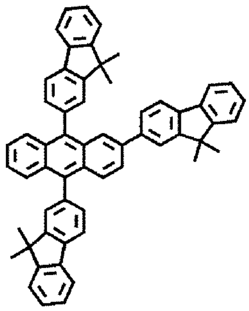

H25

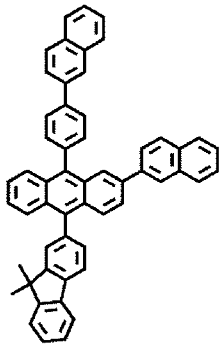

H26

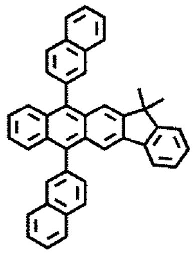

H27

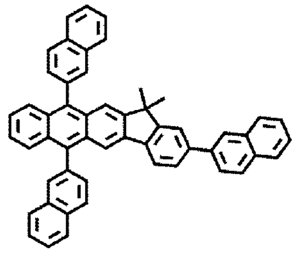

H28

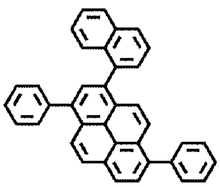

H29

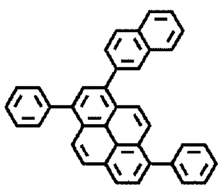

H30

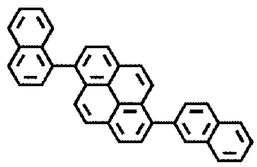

H31

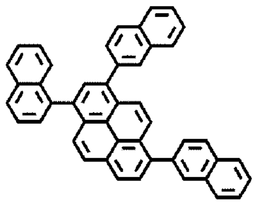

H32

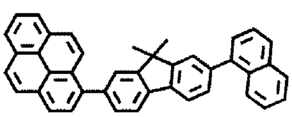

H33

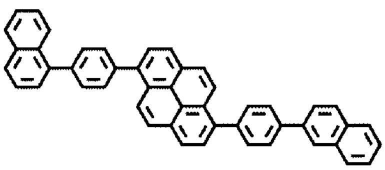

H34

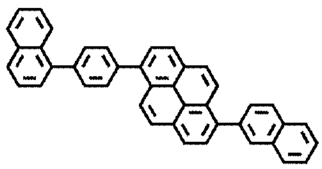

H35

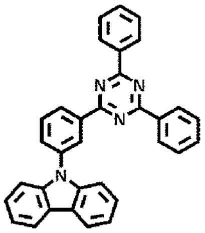
H36

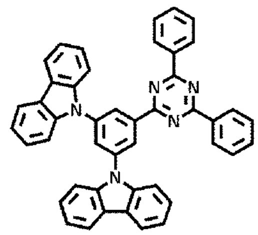
H37

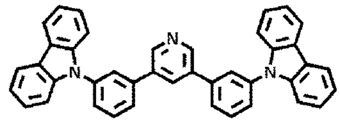
H38

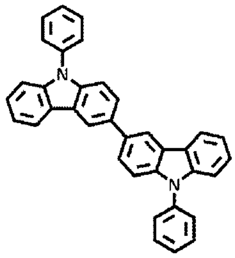
H39

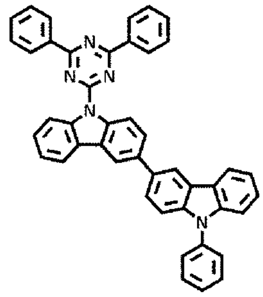
H40

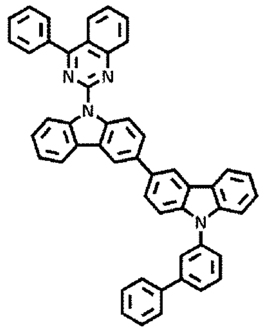
H41

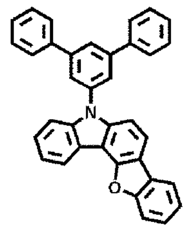
H42

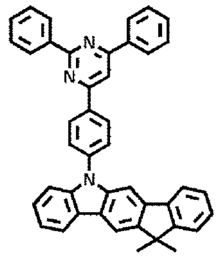
H43

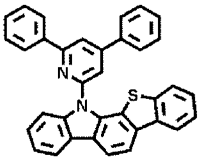
H44

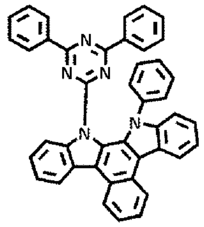
H45

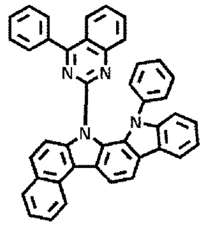
H46

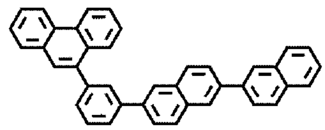
H47

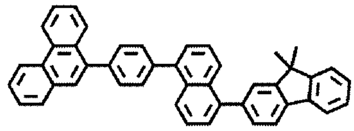
H48

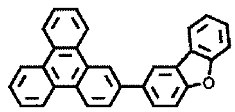
H49

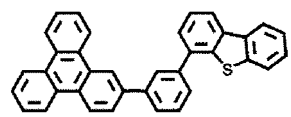
H50

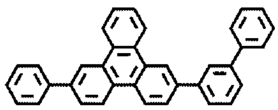
H51

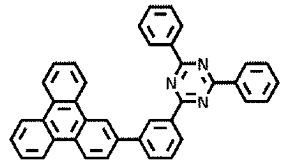
H52

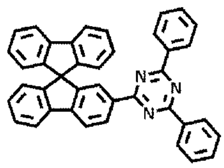
H53

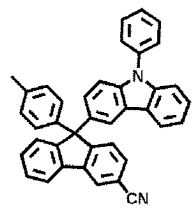
H54

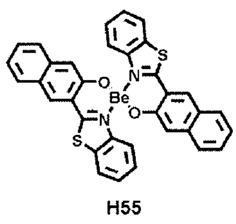
H55

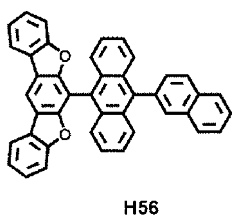
H56

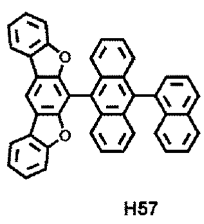
H57

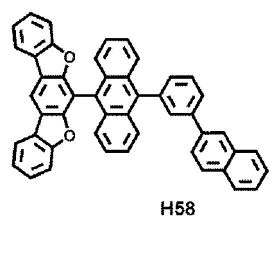
H58

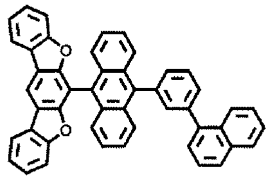
H59

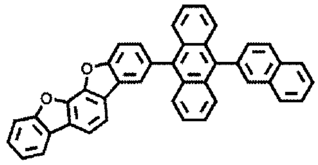
H60

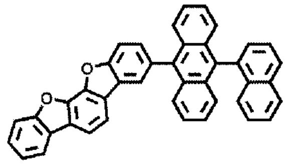
H61

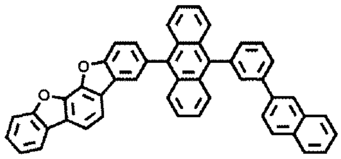
H62

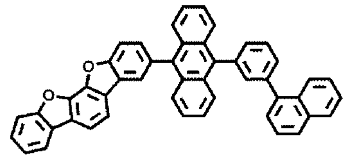
H63

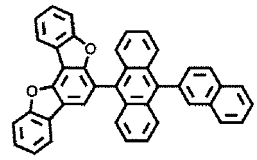
H64

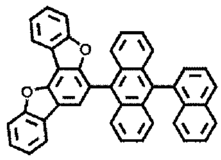
H65

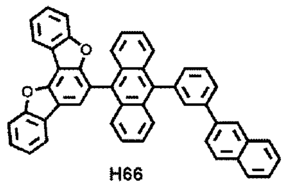
H66

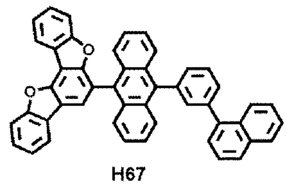
H67

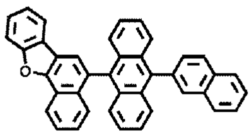
H68

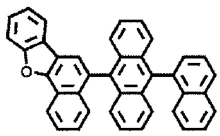
H69

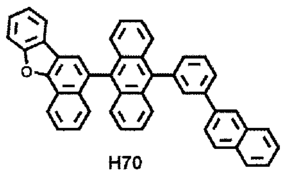
H70

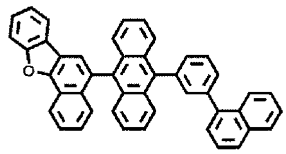
H71

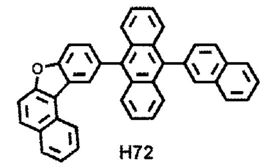
H72

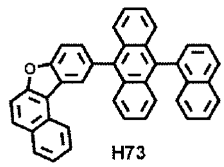
H73

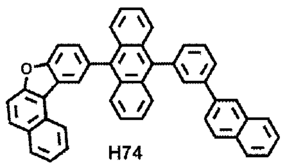
H74

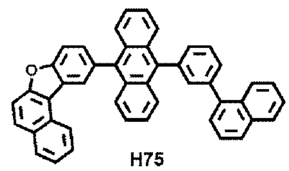
H75

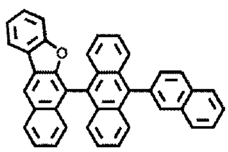
H76

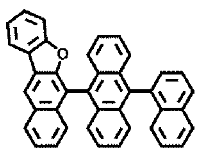
H77

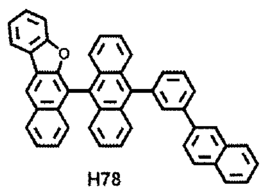
H78

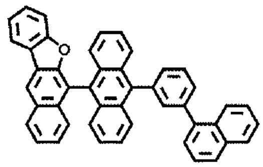
H79

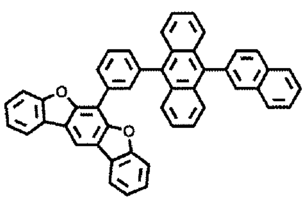
H80

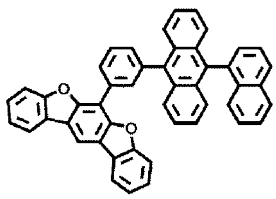
H81

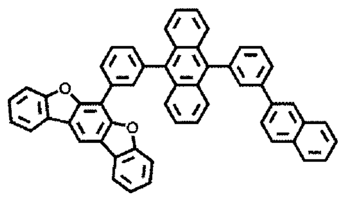
H82

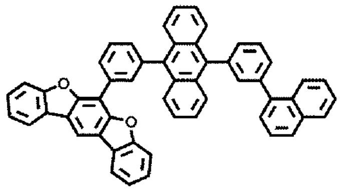
H83

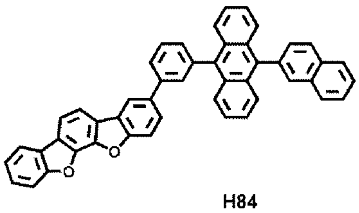
H84

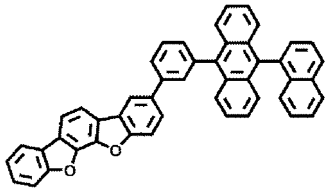
H85

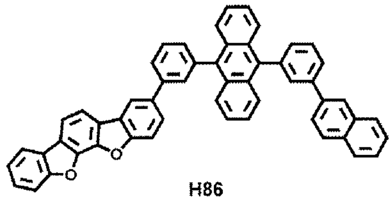
H86

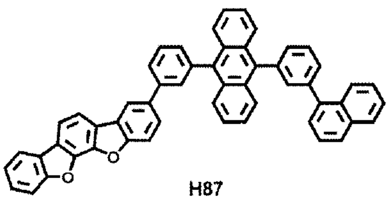
H87

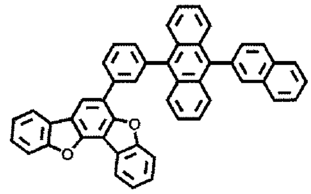
H88

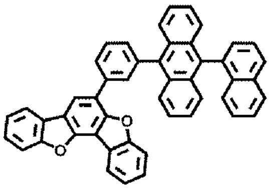
H89

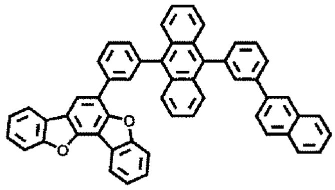
H90

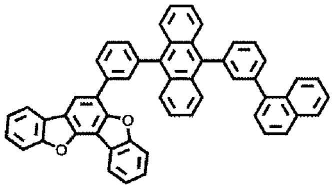
H91

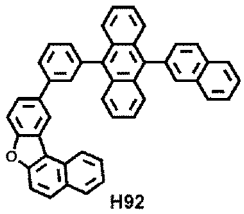
H92

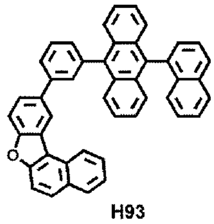
H93

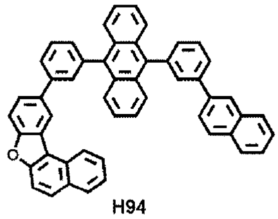
H94

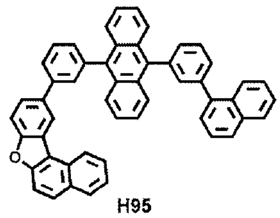
H95

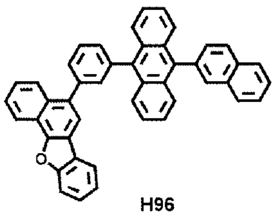
H96

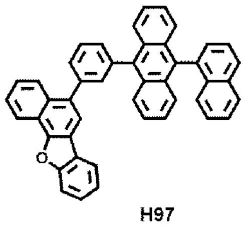
H97

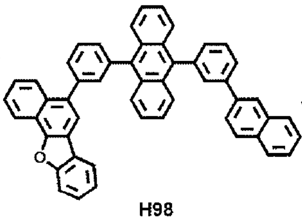
H98

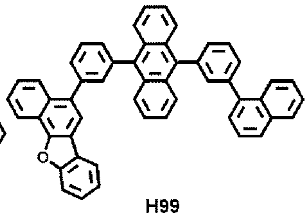
H99

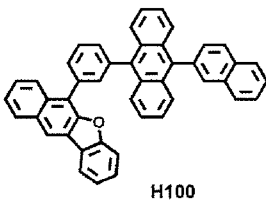
H100

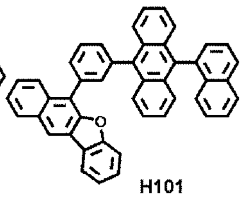
H101

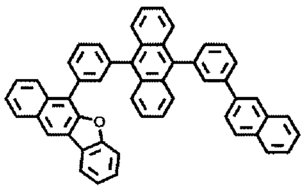
H102

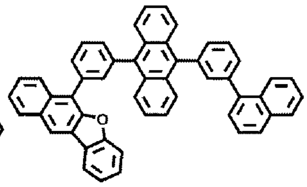
H103

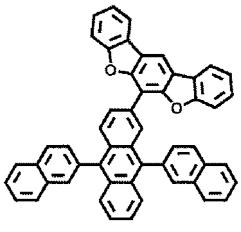
H104

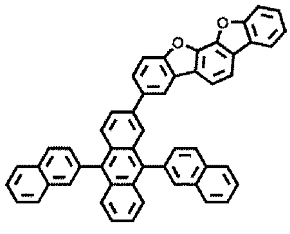
H105

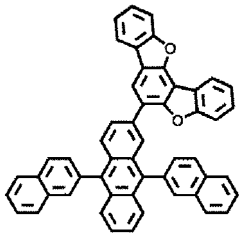
H106

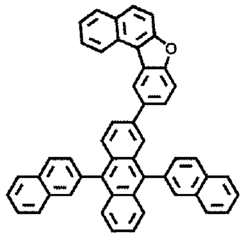
H107

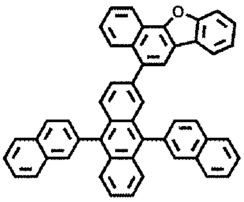
H108

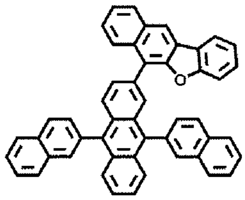
H109

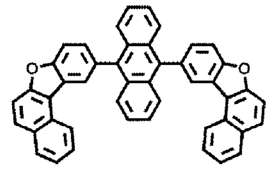
H110

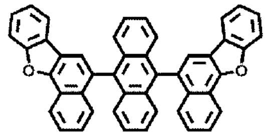
H111

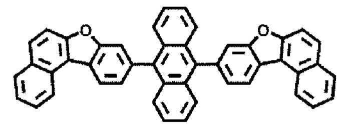
H112

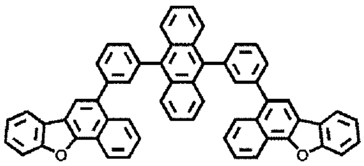
H113

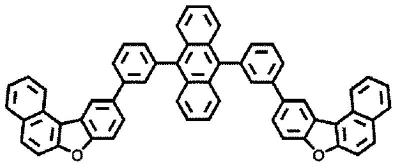
H114

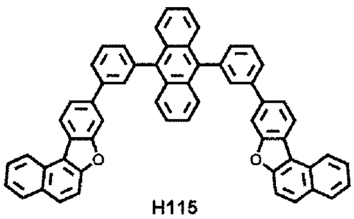
H115

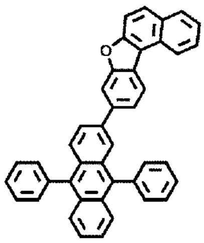
H116

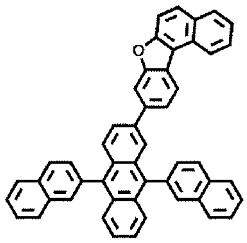
H117

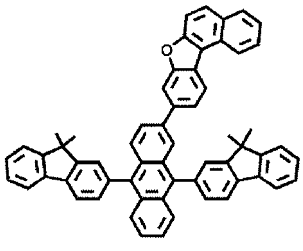
H118

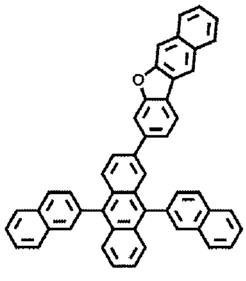
H119

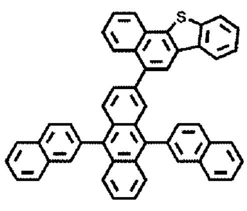
H120

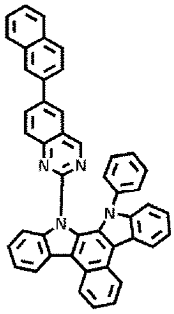

H121

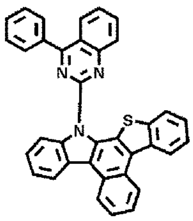

H122

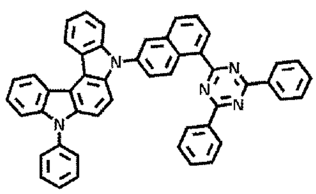

H123

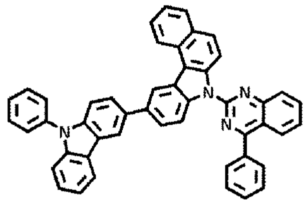

H124

.

Phosphorescent dopant

The phosphorescent dopant may include at least one transition metal as a central metal.

The phosphorescent dopant may include a monodentate ligand, a bidentate ligand, a tridentate ligand, a tetradentate ligand, a pentadentate ligand, a hexadentate ligand, or a combination thereof.

The phosphorescent dopant may be electrically neutral.

For example, the phosphorescent dopant may include an organometallic compound represented by Formula 401:

Formula 401 $M(L_{401})_{xc1}(L_{402})_{xc2}$

Formula 402

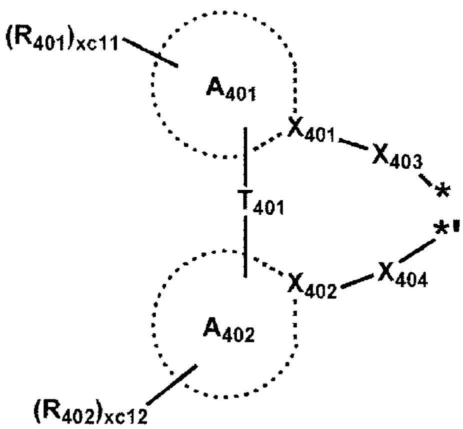

wherein, in Formulae 401 and 402,

M may be a transition metal (for example, iridium (Ir), platinum (Pt), palladium (Pd), osmium (Os), titanium (Ti), gold (Au), hafnium (Hf), europium (Eu), terbium (Tb), rhodium (Rh), rhenium (Re), or thulium (Tm)),

$L_{401}$ may be a ligand represented by Formula 402, and xc1 may be 1, 2, or 3, wherein when xc1 is two or more, two or more of $L_{401}$(s) may be identical to or different from each other,

$L_{402}$ may be an organic ligand, and xc2 may be 0, 1, 2, 3, or 4, and when xc2 is 2 or more, two or more of $L_{402}$(s) may be identical to or different from each other,

$X_{401}$ and $X_{402}$ may each independently be nitrogen or carbon,

ring $A_{401}$ and ring $A_{402}$ may each independently be a $C_3$-$C_{60}$ carbocyclic group or a $C_1$-$C_{60}$ heterocyclic group,

$T_{401}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C($Q_{411}$)=*',

$X_{403}$ and $X_{404}$ may each independently be a chemical bond (for example, a covalent bond or a coordination bond), O, S, N($Q_{413}$), B($Q_{413}$), P($Q_{413}$), C($Q_{413}$)($Q_{414}$), or Si(Q413)(Q414),

$Q_{411}$ to $Q_{414}$ may each be the same as described herein with respect to $Q_1$,

$R_{401}$ and $R_{402}$ may each independently be hydrogen, deuterium, -F, -Cl, -Br, -I, a hydroxyl group, a cyano group, a nitro

group, a $C_1$-$C_{20}$ alkyl group unsubstituted or substituted with at least one $R_{10a}$, a $C_1$-$C_{20}$ alkoxy group unsubstituted or substituted with at least one $R_{10a}$, a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, -Si($Q_{401}$)($Q_{402}$)($Q_{403}$), -N($Q_{401}$)($Q_{402}$), -B($Q_{401}$)($Q_{402}$), -C(=O)($Q_{401}$), -S(=O)$_2$($Q_{401}$), or - P(=O)($Q_{401}$)($Q_{402}$),
$Q_{401}$ to $Q_{403}$ may each be the same as described herein with respect to $Q_1$,
xc11 and xc12 may each independently be an integer from 0 to 10, and
* and *' in Formula 402 each indicate a binding site to M in Formula 401.

For example, in Formula 402, i) $X_{401}$ may be nitrogen, and $X_{402}$ may be carbon, or ii) each of $X_{401}$ and $X_{402}$ may be nitrogen.
As another example, when xc1 in Formula 401 is 2 or more, two ring $A_{401}$(s) in two or more of $L_{401}$(s) may be optionally linked to each other via $T_{402}$, which is a linking group, or two ring $A_{402}$(s) may be optionally linked to each other via $T_{403}$, which is a linking group
(see Compounds PD1 to PD4 and PD7). $T_{402}$ and $T_{403}$ may each be the same as described herein with respect to $T_{401}$.
$L_{402}$ in Formula 401 may be an organic ligand. For example, $L_{402}$ may include a halogen group, a diketone group (for example, an acetylacetonate group), a carboxylic acid group (for example, a picolinate group), -C(=O), an isonitrile group, -CN group, a phosphorus group (for example, a phosphine group, a phosphite group, and/or the like), or a combination thereof.
The phosphorescent dopant may include, for example, at least one selected from among compounds PD1 to PD39, or a combination thereof:

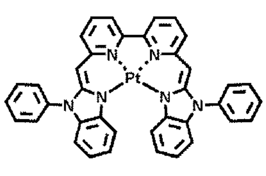
PD1

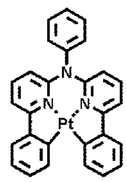
PD2

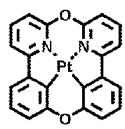
PD3

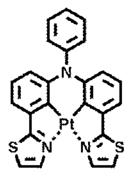
PD4

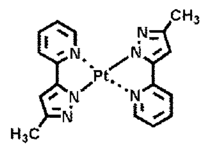
PD5

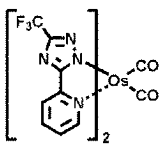
PD6

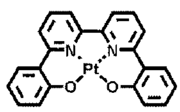
PD7

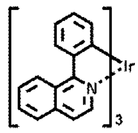
PD8

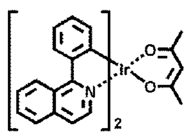
PD9

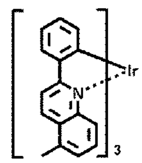
PD10

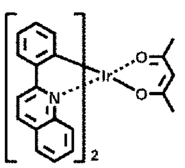
PD11

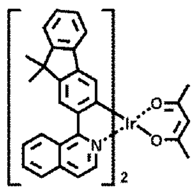
PD12

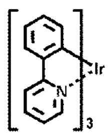
PD13

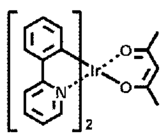
PD14

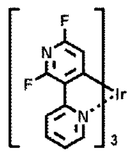
PD15

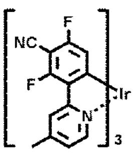
PD16

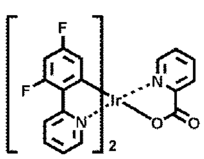
PD17

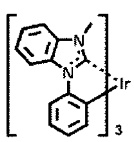
PD18

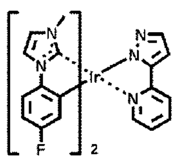
PD19

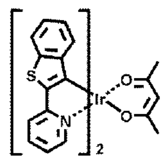
PD20

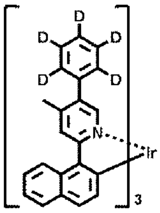
PD21

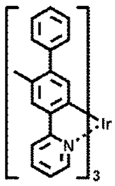
PD22

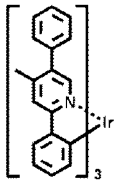
PD23

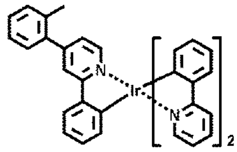
PD24

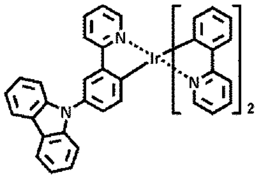
PD25

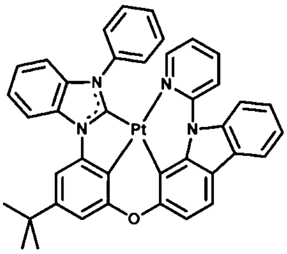
PD26

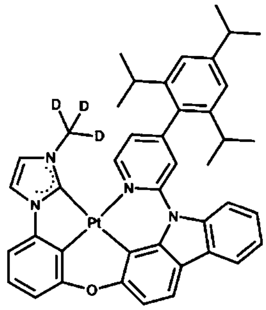
PD27

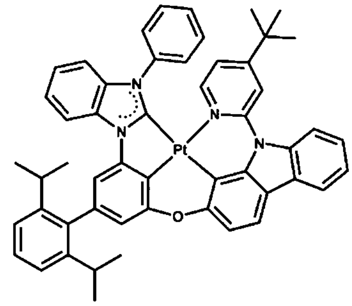
PD28

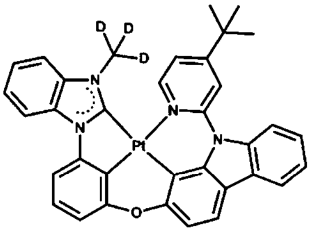
PD29

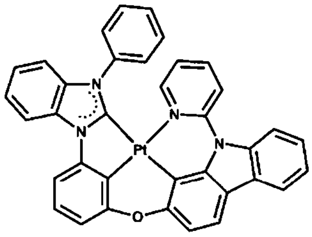
PD30

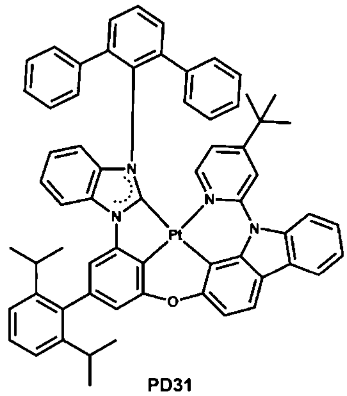
PD31

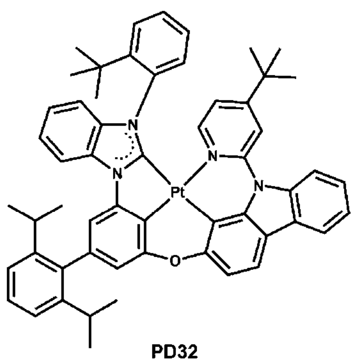
PD32

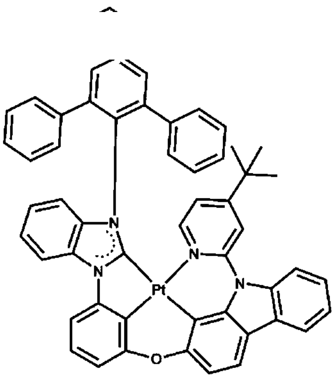
PD33

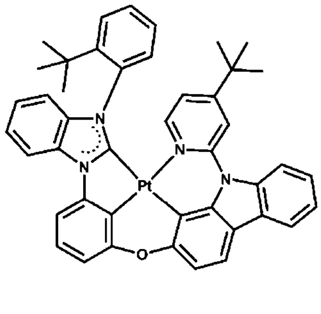
PD34

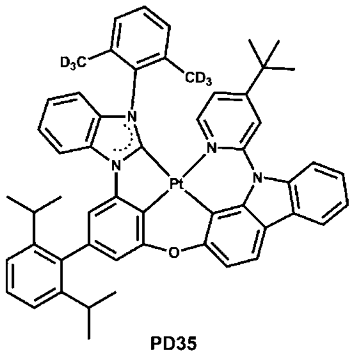
PD35

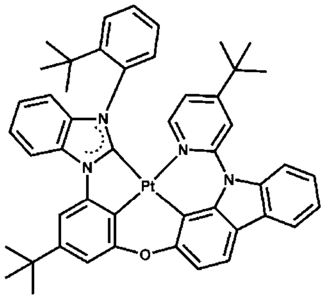
PD36

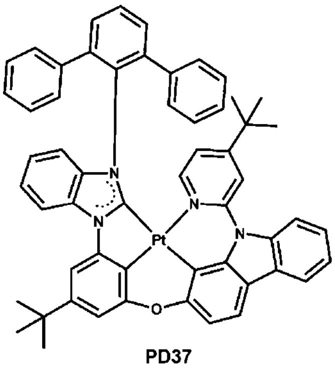
PD37

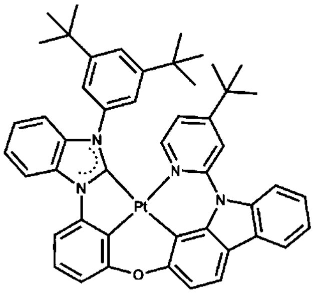
PD38

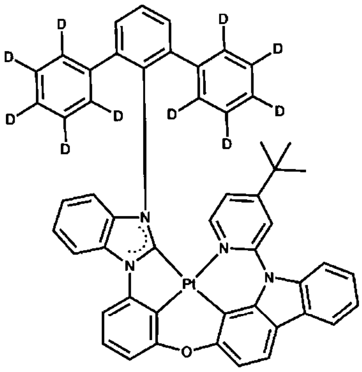
PD39

.

Fluorescent dopant

The fluorescent dopant may include an amine group-containing compound, a styryl group-containing compound, or a combination thereof.

For example, the fluorescent dopant may include a compound represented by Formula 501:

Formula 501

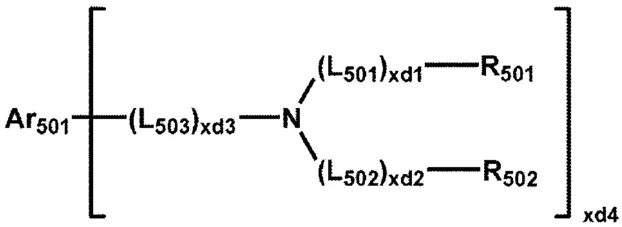

wherein, in Formula 501,

$Ar_{501}$, $L_{501}$ to $L_{503}$, $R_{501}$, and $R_{502}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,

xd1 to xd3 may each independently be 0, 1, 2, or 3, and

xd4 may be 1, 2, 3, 4, 5, or 6.

For example, $Ar_{501}$ in Formula 501 may be a condensed cyclic group (for example, an anthracene group, a chrysene group, or a pyrene group) in which three or more monocyclic groups are condensed together.

As another example, xd4 in Formula 501 may be 2.

For example, the fluorescent dopant may include: at least one selected from among Compounds FD1 to FD36; DPVBi; DPAVBi; and/or a combination thereof:

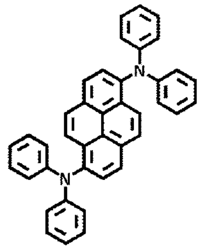
FD1

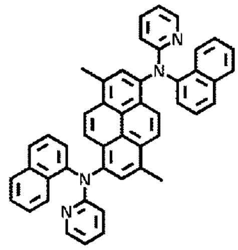
FD2

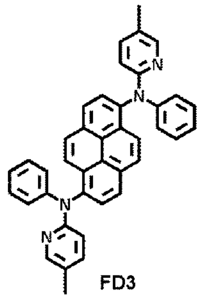
FD3

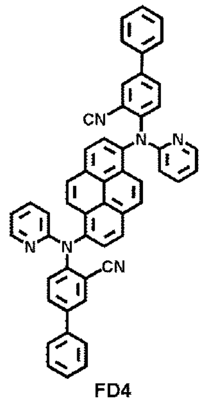
FD4

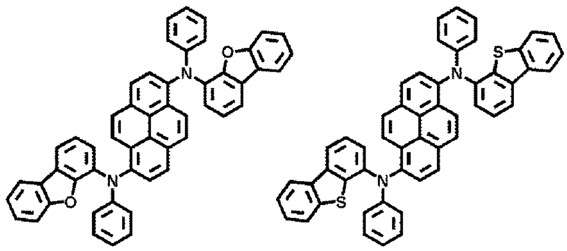
FD5

FD6

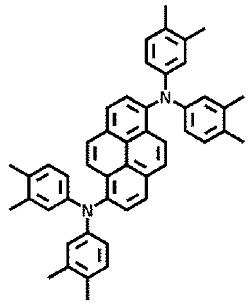
FD7

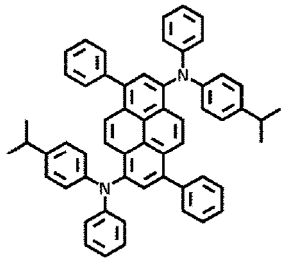
FD8

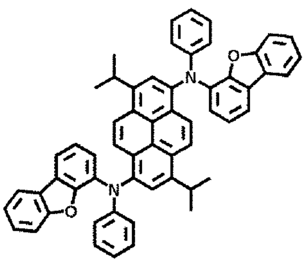
FD9

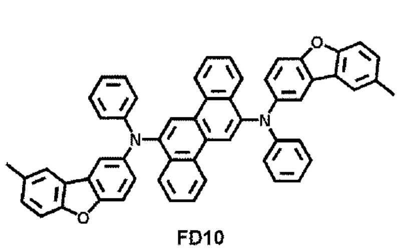
FD10

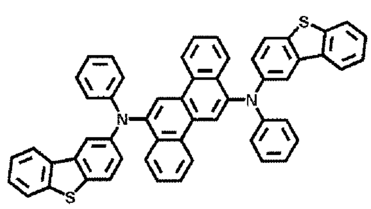
FD11

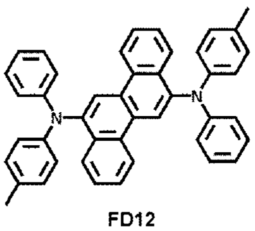
FD12

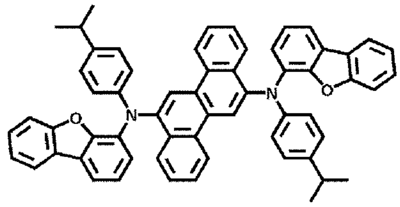
FD13

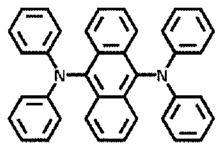
FD14

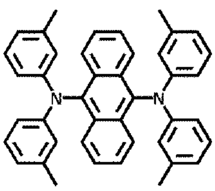
FD15

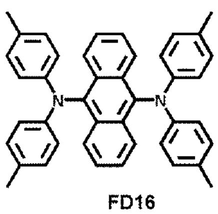
FD16

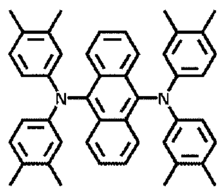
FD17

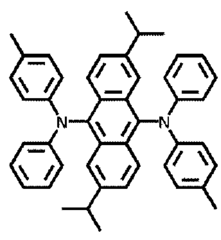
FD18

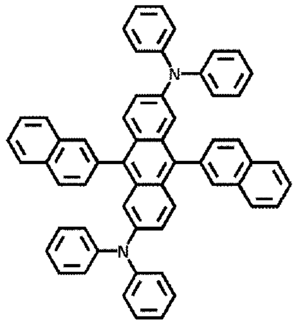

FD19

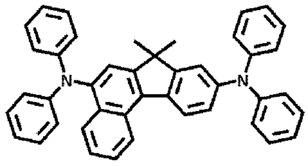

FD20

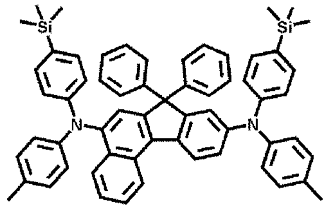

FD21

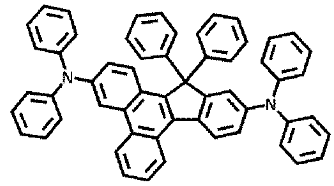

FD22

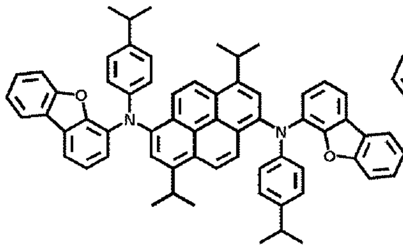

FD23

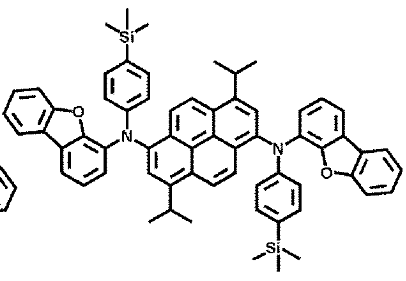

FD24

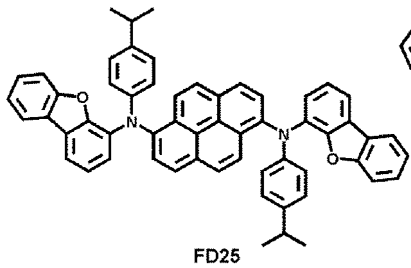

FD25

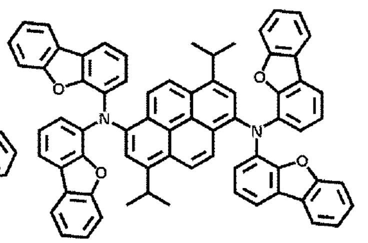

FD26

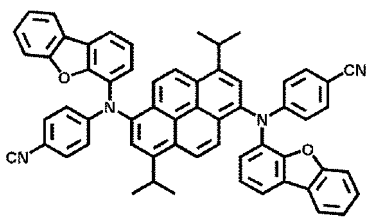

FD27

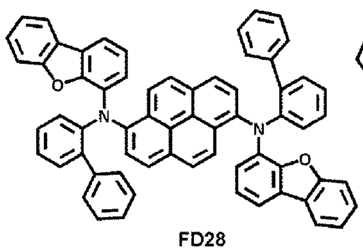

FD28

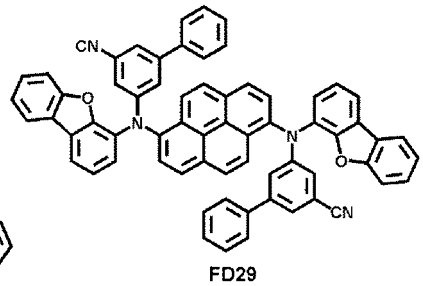

FD29

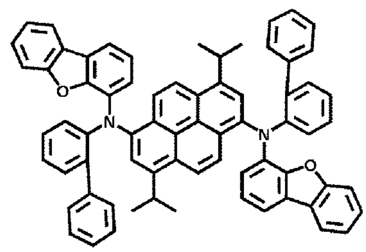

FD30

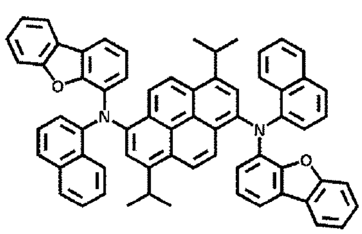

FD31

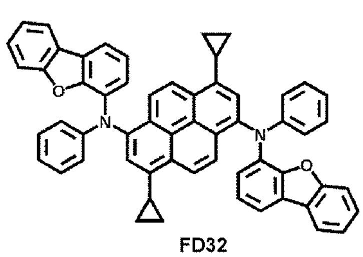

FD32

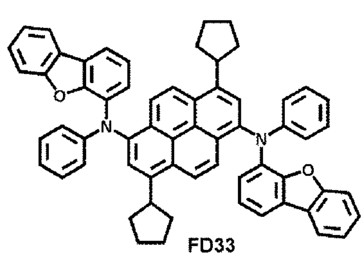

FD33

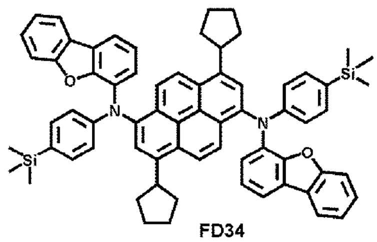
FD34

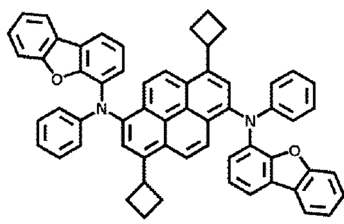
FD35

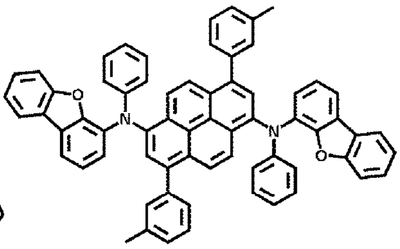
FD36

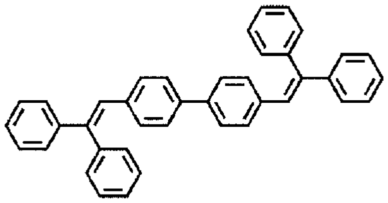
DPVBi

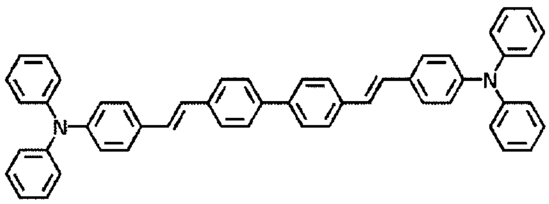
DPAVBi

Delayed fluorescence material

The emission layer may include a delayed fluorescence material.

In the present specification, the delayed fluorescence material may be selected from compounds capable of emitting delayed fluorescent light based on a delayed fluorescence emission mechanism.

The delayed fluorescence material included in the emission layer may act as a host or a dopant depending on the type or kind of other materials included in the emission layer.

According to an embodiment, the difference between the triplet energy level (eV) of the delayed fluorescence material and the singlet energy level (eV) of the delayed fluorescence material may be greater than or equal to 0 eV and less than or equal to 0.5 eV. When the difference between the triplet energy level (eV) of the delayed fluorescence material and the singlet energy level (eV) of the delayed fluorescence material satisfies the herein-described range, up-conversion from the triplet state to the singlet state of the delayed fluorescence materials may effectively occur, and thus, the luminescence efficiency of the light-emitting device 30 may be improved.

For example, the delayed fluorescence material may include i) a material including at least one electron donor (for example, a $\pi$ electron-rich $C_3$-$C_{60}$ cyclic group, such as a carbazole group) and at least one electron acceptor (for example, a sulfoxide group, a cyano group, or a $\pi$ electron-deficient nitrogen-containing $C_1$-$C_{60}$ cyclic group), and ii) a material including a $C_8$-$C_{60}$ polycyclic group in which two or more cyclic groups are condensed while sharing boron (B).

Examples of the delayed fluorescence material may include at least one of the following compounds DF1 to DF9:

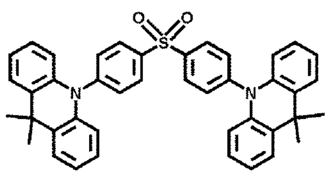
DF1(DMAC-DPS)

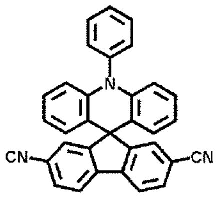
DF2(ACRFLCN)

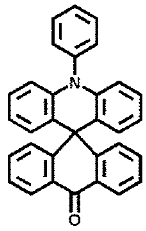
DF3(ACRSA)

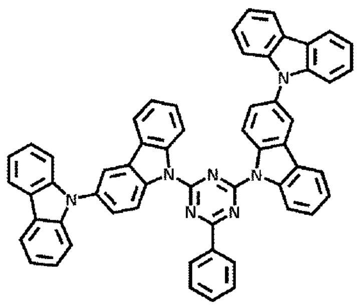
DF4(CC2TA)

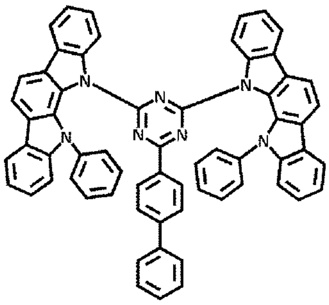

DF5(PIC-TRZ)

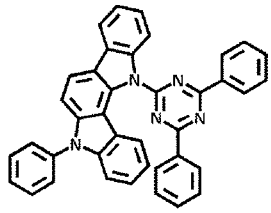

DF6(PIC-TRZ2)

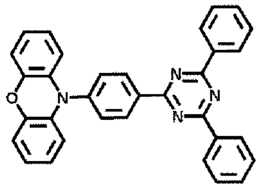

DF7(PXZ-TRZ)

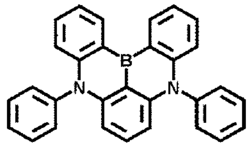

DF8(DABNA-1)

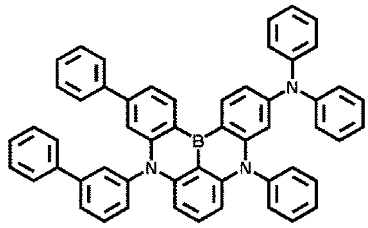

DF9(DABNA-2)

.

Electron transport region in interlayer 130

The electron transport region may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron transport region may include a buffer layer, a hole-blocking layer, an electron control layer, an electron-transporting layer, an electron injection layer, or a combination thereof.

For example, the electron transport region may have an electron transport layer/electron injection layer structure, a hole-blocking layer/electron transport layer/electron injection layer structure, an electron control layer/electron transport layer/electron injection layer structure, or a buffer layer/electron transport layer/electron injection layer structure, the layers of each structure being sequentially stacked from the emission layer.

The electron transport region (for example, the buffer layer, the hole-blocking layer, the electron control layer, or the electron transport layer in the electron transport region) may include a metal-free compound including at least one $\pi$ electron-deficient nitrogen-containing $C_1$-$C_{60}$ cyclic group.

For example, the electron transport region may include a compound represented by Formula 601:

Formula 601 $[Ar_{601}]_{xe11}$-$[(L_{601})_{xe1}$-$R_{601}]_{xe21}$

wherein, in Formula 601,

- $Ar_{601}$ and $L_{601}$ may each independently be a $C_3$-$C_{60}$ carbocyclic group unsubstituted or substituted with at least one $R_{10a}$ or a $C_1$-$C_{60}$ heterocyclic group unsubstituted or substituted with at least one $R_{10a}$,
- xe11 may be 1, 2, or 3,
- xe1 may be 0, 1, 2, 3, 4, or 5,
- $R_{601}$ may be a $C_3$-$C_{60}$ carbocyclic group unsubstituted or substituted with at least one $R_{10a}$, a $C_1$-$C_{60}$ heterocyclic group unsubstituted or substituted with at least one $R_{10a}$, $-Si(Q_{601})(Q_{602})(Q_{603})$, $-C(=O)(Q_{601})$, $-S(=O)_2(Q_{601})$, or $-P(=O)(Q_{601})(Q_{602})$,
- $Q_{601}$ to $Q_{603}$ may each be the same as described herein with respect to $Q_1$, xe21 may be 1, 2, 3, 4, or 5,
- at least one selected from among $Ar_{601}$, $L_{601}$, and $R_{601}$ may each independently be a $\pi$ electron-deficient nitrogen-containing $C_1$-$C_{60}$ cyclic group unsubstituted or substituted with at least one $R_{10a}$.

For example, when xe11 in Formula 601 is 2 or more, two or more of $Ar_{601}$(s) may be linked to each other via a single bond.

As another example, $Ar_{601}$ in Formula 601 may be a substituted or unsubstituted anthracene group.

As another example, the electron transport region may include a compound represented by Formula 601-1:

Formula 601-1

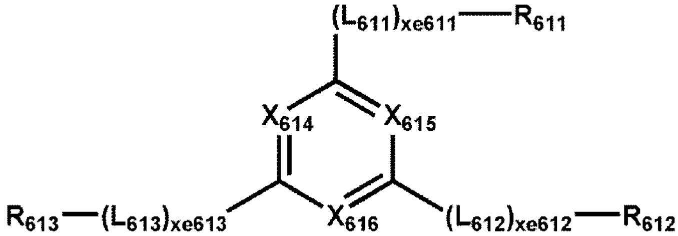

wherein, in Formula 601-1,

$X_{614}$ may be N or $C(R_{614})$, $X_{615}$ may be N or $C(R_{615})$, $X_{616}$ may be N or $C(R_{616})$, and at least one selected from among $X_{614}$ to $X_{616}$ may be N,
$L_{611}$ to $L_{613}$ may each be the same as described herein with respect to $L_{601}$,
xe611 to xe613 may each be the same as described herein with respect to xe1,
$R_{611}$ to $R_{613}$ may each be the same as described herein with respect to $R_{601}$, and
$R_{614}$ to $R_{616}$ may each independently be hydrogen, deuterium, -F, -Cl, -Br, -I, a hydroxyl group, a cyano group, a nitro group, a $C_1$-$C_{20}$ alkyl group, a $C_1$-$C_{20}$ alkoxy group, a $C_3$-$C_{60}$ carbocyclic group unsubstituted or substituted with at least one $R_{10a}$, or a $C_1$-$C_{60}$ heterocyclic group unsubstituted or substituted with at least one $R_{10a}$.

For example, xe1 and xe611 to xe613 in Formulae 601 and 601-1 may each independently be 0, 1, or 2.
The electron transport region may include at least one selected from among Compounds ET1 to ET45, 2,9-dimethyl-4,7-diphenyl-1,10-phenanthroline (BCP), 4,7-diphenyl-1,10-phenanthroline (Bphen), $Alq_3$, BAlq, TAZ, NTAZ, and/or a combination thereof:

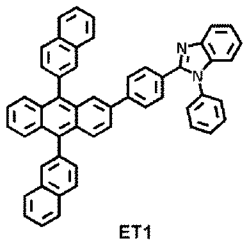
ET1

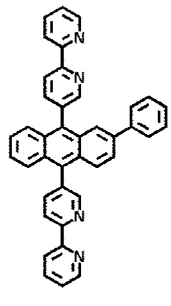
ET2

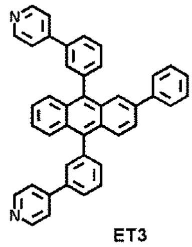
ET3

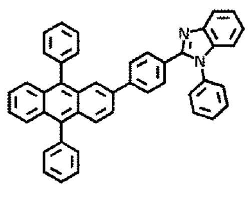
ET4

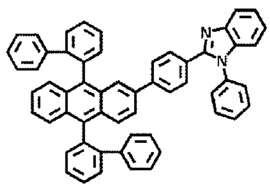
ET5

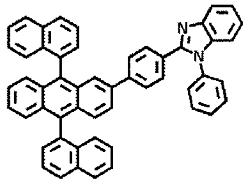
ET6

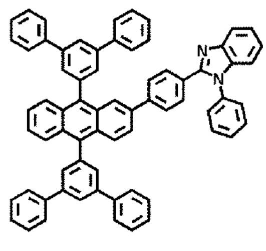
ET7

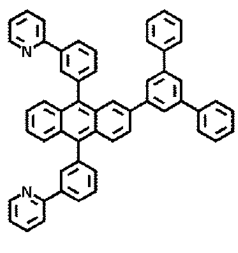
ET8

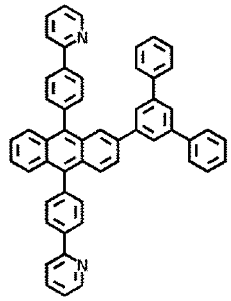

ET9

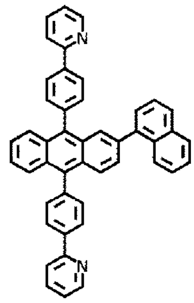

ET10

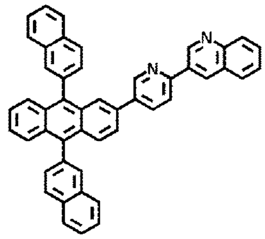

ET11

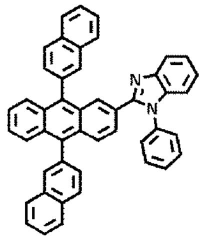

ET12

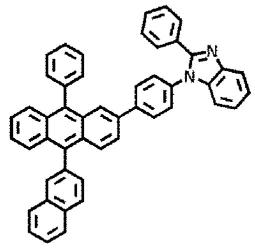

ET13

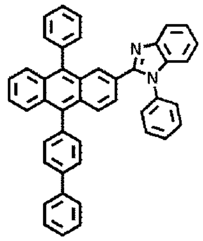

ET14

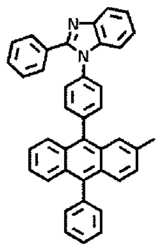

ET15

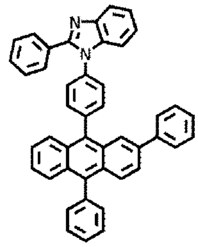

ET16

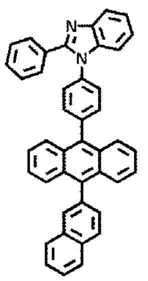

ET17

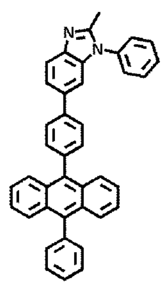

ET18

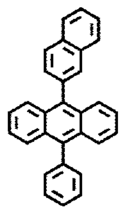

ET19

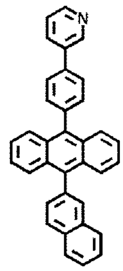

ET20

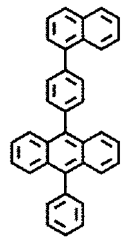

ET21

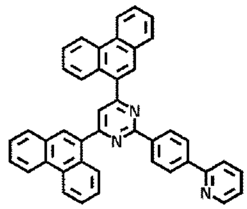

ET22

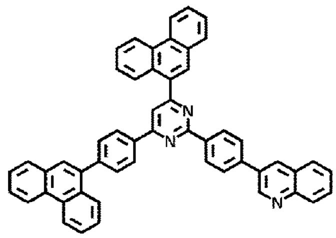

ET23

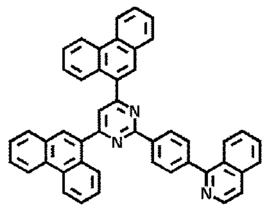

ET24

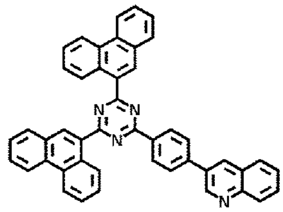

ET25

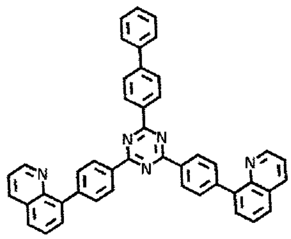

ET26

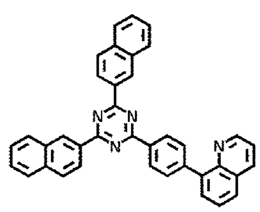

ET27

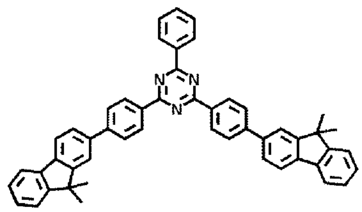

ET28

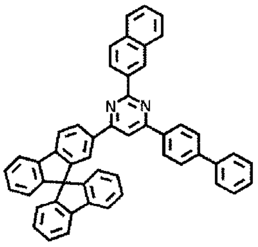
ET29

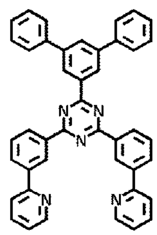
ET30

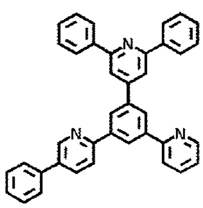
ET31

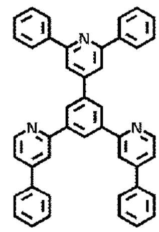
ET32

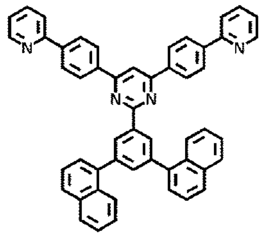
ET33

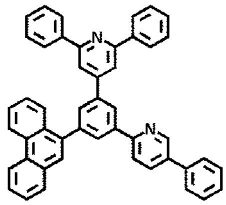
ET34

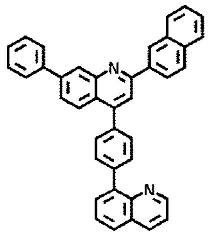
ET35

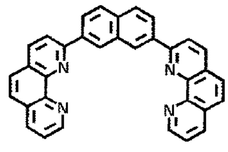
ET36

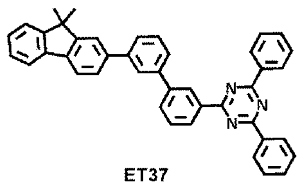
ET37

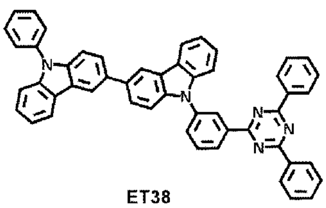
ET38

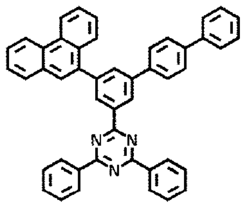
ET39

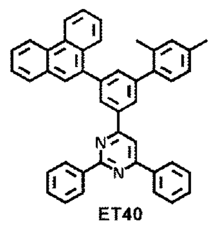
ET40

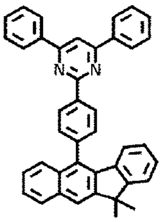
ET41

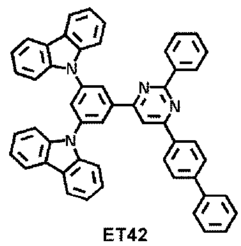
ET42

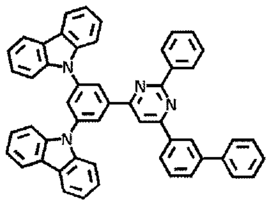
ET43

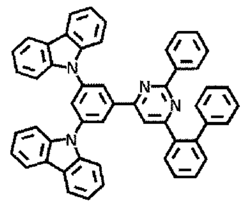
ET44

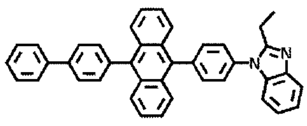
ET45

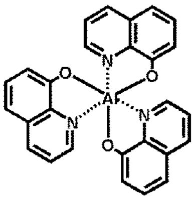
$Alq_3$

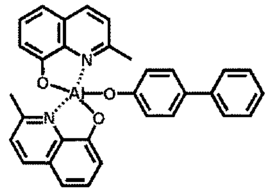
BAlq

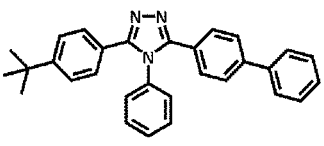
TAZ

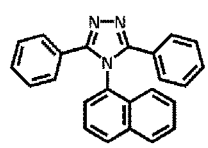
NTAZ .

A thickness of the electron transport region may be from about 100 Å to about 5,000 Å, for example, about 160 Å to about 4,000 Å. When the electron transport region includes a buffer layer, a hole-blocking layer, an electron control layer, an electron transport layer, or a combination thereof, the thickness of the buffer layer, the hole-blocking layer, or the electron control layer may each independently be from about 20 Å to about 1000 Å, for example, about 30 Å to about 300 Å, and the thickness of the electron transport layer may be from about 100 Å to about 1000 Å, for example, about 150 Å to

about 500 Å. When the thickness of the buffer layer, the hole-blocking layer, the electron control layer, the electron transport layer, and/or the electron transport layer are within these ranges, satisfactory electron transporting characteristics may be obtained without a substantial increase in driving voltage.

The electron transport region (for example, the electron transport layer in the electron transport region) may further include, in addition to the materials described herein, a metal-containing material.

The metal-containing material may include an alkali metal complex, an alkaline earth metal complex, or a combination thereof. The metal ion of an alkali metal complex may be a Li ion, a Na ion, a K ion, a Rb ion, or a Cs ion, and the metal ion of an alkaline earth metal complex may be a Be ion, a Mg ion, a Ca ion, a Sr ion, or a Ba ion. A ligand coordinated with the metal ion of the alkali metal complex or the alkaline earth-metal complex may include a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxyphenyloxadiazole, a hydroxyphenylthiadiazole, a hydroxyphenylpyridine, a hydroxyphenylbenzimidazole, a hydroxyphenylbenzothiazole, a bipyridine, a phenanthroline, a cyclopentadiene, or a combination thereof.

For example, the metal-containing material may include a Li complex. The Li complex may include, for example, Compound ET-D1 (LiQ) or ET-D2:

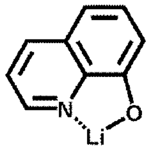

ET-D1

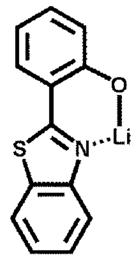

ET-D2 .

The electron transport region may include an electron injection layer that facilitates the injection of electrons from the second electrode 150. The electron injection layer may directly contact the second electrode 150.

The electron injection layer may have: i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure including a plurality of layers including different materials.

The electron injection layer may include an alkali metal, an alkaline earth metal, a rare earth metal, an alkali metal-containing compound, alkaline earth metal-containing compound, a rare earth metal-containing compound, an alkali metal complex, an alkaline earth metal complex, a rare earth metal complex, or a combination thereof.

The alkali metal may include Li, Na, K, Rb, Cs, or a combination thereof. The alkaline earth metal may include Mg, Ca, Sr, Ba, or a combination thereof. The rare earth metal may include Sc, Y, Ce, Tb, Yb, Gd, or a combination thereof.

The alkali metal-containing compound, the alkaline earth metal-containing compound, and the rare earth metal-containing compound may be oxides, halides (for example, fluorides, chlorides, bromides, or iodides), or tellurides of the alkali metal, the alkaline earth metal, and the rare earth metal, or a combination thereof.

The alkali metal-containing compound may include: alkali metal oxides, such as $Li_2O$, $Cs_2O$, or $K_2O$; alkali metal halides, such as LiF, NaF, CsF, KF, LiI, NaI, CsI, or KI; or a combination thereof. The alkaline earth metal-containing compound may include an alkaline earth metal compound, such as BaO, SrO, CaO, $Ba_xSr_{1-x}O$ (wherein x is a real number satisfying the condition of 0<x<1), $Ba_xCa_{1-x}O$ (wherein x is a real number satisfying the condition of 0<x<1), and/or the like. The rare earth metal-containing compound may include $YbF_3$, $ScF_3$, $Sc_2O_3$, $Y_2O_3$, $Ce_2O_3$, $GdF_3$, $TbF_3$, $YbI_3$, $ScI_3$, $TbI_3$, or a combination thereof. Alternatively, the rare earth metal-containing compound may include lanthanide metal telluride. Examples of the lanthanide metal telluride are LaTe, CeTe, PrTe, NdTe, PmTe, SmTe, EuTe, GdTe, TbTe, DyTe, HoTe, ErTe, TmTe, YbTe, LuTe, $La_2Te_3$, $Ce_2Te_3$, $Pr_2Te_3$, $Nd_2Te_3$, $Pm_2Te_3$, $Sm_2Te_3$, $Eu_2Te_3$, $Gd_2Te_3$, $Tb_2Te_3$, $Dy_2Te_3$, $Ho_2Te_3$, $Er_2Te_3$, $Tm_2Te_3$, $Yb_2Te_3$, and $Lu_2Te_3$.

The alkali metal complex, the alkaline earth-metal complex, and the rare earth metal complex may include i) one of ions of the alkali metal, the alkaline earth metal, and the rare earth metal and ii), as a ligand bonded to the metal ion, for example, hydroxyquinoline, hydroxyisoquinoline, hydroxybenzoquinoline, hydroxyacridine, hydroxyphenanthridine, hydroxyphenyloxazole, hydroxyphenylthiazole, hydroxyphenyloxadiazole, hydroxyphenylthiadiazole, hydroxyphenylpyridine, hydroxyphenyl benzimidazole, hydroxyphenylbenzothiazole, bipyridine, phenanthroline, cyclopentadiene, or a combination thereof.

The electron injection layer may consist of an alkali metal, an alkaline earth metal, a rare earth metal, an alkali metal-containing compound, an alkaline earth metal-containing compound, a rare earth metal-containing compound, an

alkali metal complex, an alkaline earth metal complex, a rare earth metal complex, or a combination thereof, as described herein, or the electron injection layer may further include an organic material (for example, a compound represented by Formula 601).

In an embodiment, the electron injection layer may consist of i) an alkali metal-containing compound (for example, alkali metal halide), and/or ii) a) an alkali metal-containing compound (for example, alkali metal halide) and b) an alkali metal, an alkaline earth metal, a rare earth metal, or a combination thereof. For example, the electron injection layer may be a KI:Yb co-deposited layer, an RbI:Yb co-deposited layer, and/or the like.

When the electron injection layer further includes an organic material, an alkali metal, an alkaline earth metal, a rare earth metal, an alkali metal-containing compound, an alkaline earth metal-containing compound, a rare earth metal-containing compound, an alkali metal complex, an alkaline earth-metal complex, a rare earth metal complex, or a combination thereof may be uniformly or non-uniformly dispersed in a matrix including the organic material.

A thickness of the electron injection layer may be in a range of about 1 Å to about 100 Å, and, for example, about 3 Å to about 90 Å. When the thickness of the electron injection layer is within the ranges described herein, satisfactory electron injection characteristics may be obtained without a substantial increase in driving voltage.

Second electrode 150

The second electrode 150 may be located on the interlayer 130 having a structure as described herein. The second electrode 150 may be a cathode, which is an electron injection electrode, and as the material for the second electrode 150, a metal, an alloy, an electrically conductive compound, or a combination thereof, each having a low-work function, may be utilized.

The second electrode 150 may include lithium (Li), silver (Ag), magnesium (Mg), aluminium (Al), aluminium-lithium (Al-Li), calcium (Ca), magnesium-indium (Mg-In), magnesium-silver (Mg-Ag), ytterbium (Yb), silver-ytterbium (Ag-Yb), ITO, IZO, or a combination thereof. The second electrode 150 may be a transmissive electrode, a semi-transmissive electrode, or a reflective electrode.

The second electrode 150 may have a single-layered structure or a multi-layered structure including a plurality of layers.

Capping layer

A first capping layer may be located outside the first electrode 110, and/or a second capping layer may be located outside the second electrode 150. Specifically, the light-emitting device 30 may have a structure in which the first capping layer, the first electrode 110, the interlayer 130, and the second electrode 150 are sequentially stacked in the stated order, a structure in which the first electrode 110, the interlayer 130, the second electrode 150, and the second capping layer are sequentially stacked in the stated order, or a structure in which the first capping layer, the first electrode 110, the interlayer 130, the second electrode 150, and the second capping layer are sequentially stacked in the stated order.

Light generated in an emission layer of the interlayer 130 of the light-emitting device 30 may be extracted toward the outside through the first electrode 110 which is a semi-transmissive electrode or a transmissive electrode, and the first capping layer. Light generated in an emission layer of the interlayer 130 of the light-emitting device 30 may be extracted toward the outside through the second electrode 150 which is a semi-transmissive electrode or a transmissive electrode, and the second capping layer.

The first capping layer and the second capping layer may increase external emission efficiency according to the principle of constructive interference. Accordingly, the light extraction efficiency of the light-emitting device 30 may be increased, so that the luminescence efficiency of the light-emitting device 30 may be improved.

Each of the first capping layer and the second capping layer may include a material having a refractive index of 1.6 or more (at 589 nm).

The first capping layer and the second capping layer may each independently be an organic capping layer including an organic material, an inorganic capping layer including an inorganic material, or an organic-inorganic composite capping layer including an organic material and an inorganic material.

At least one of the first capping layer or the second capping layer may each independently include carbocyclic compounds, heterocyclic compounds, amine group-containing compounds, porphine derivatives, phthalocyanine derivatives, naphthalocyanine derivatives, alkali metal complexes, alkaline earth metal complexes, or a combination thereof. Optionally, the carbocyclic compound, the heterocyclic compound, and the amine group-containing compound may be substituted with a substituent including O, N, S, Se, Si, F, Cl, Br, I, or a combination thereof. According to an embodiment, at least one of the first capping layer or the second capping layer may each independently include an amine group-containing compound.

For example, at least one of the first capping layer or the second capping layer may each independently include a compound represented by Formula 201, a compound represented by Formula 202, or a combination thereof.

In one or more embodiments, at least one selected from among the first capping layer and the second capping layer may each independently include one selected from among Compounds HT28 to HT33, Compounds CP1 to CP6, β-NPB, and/or a combination thereof:

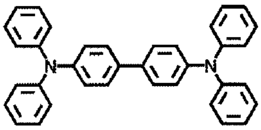

CP1

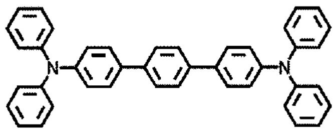

CP2

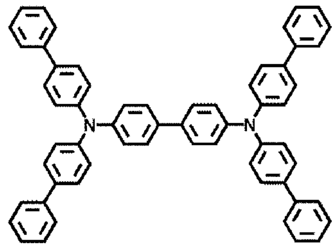

CP3

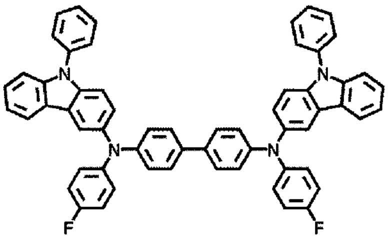

CP4

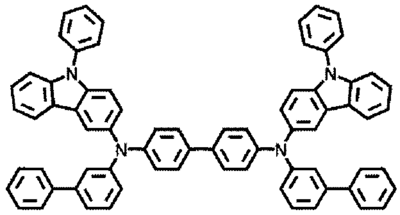

CP5

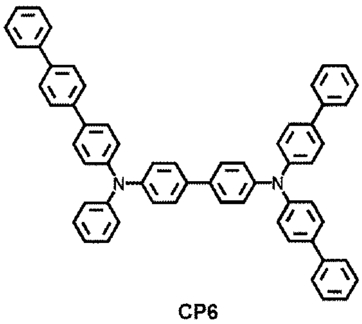

CP6

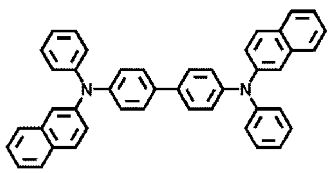

β-NPB .

Film

The herein-described quantum dots may be included in one or more suitable films. Thus, according to another aspect, a film may include the quantum dots. The film may be, for example, an optical member (or a light control component or member) (for example, a color filter, a color conversion member, a capping layer, a light extraction efficiency enhancement layer, a selective light absorbing layer, a polarizing layer, a quantum dot-containing layer, or like), a light-blocking member (for example, a light reflective layer, a light absorbing layer, and/or the like), or a protective member (for example, an insulating layer, a dielectric layer, and/or the like).

Electronic apparatus

The light-emitting device may be included in one or more suitable electronic apparatuses. For example, the electronic apparatus including the light-emitting device may be a light-emitting apparatus, an authentication apparatus, and/or the like.

The electronic apparatus (for example, a light-emitting apparatus) may further include, in addition to the light-emitting device, i) a color filter, ii) a color conversion layer, or iii) a color filter and a color conversion layer. The color filter and/or the color conversion layer may be located in at least one direction in which light emitted from the light-emitting device travels. For example, the light emitted from the light-emitting device may be blue light or white light. For details on the light-emitting device, related description provided herein may be referred to. According to an embodiment, the color conversion layer may include a quantum dot. The quantum dot may be, for example, a quantum dot as described herein.

The electronic apparatus may include a first substrate. The first substrate may include a plurality of subpixel regions, the color filter may include a plurality of color filter regions respectively corresponding to the subpixel regions, and

the color conversion layer may include a plurality of color conversion regions respectively corresponding to the subpixel regions.

A pixel-defining film may be located among the subpixel regions to define each of the subpixel regions.

The color filter may further include a plurality of color filter regions and light-shielding patterns located among the color filter regions, and the color conversion layer may further include a plurality of color conversion regions and light-shielding patterns located among the color conversion regions.

The plurality of color filter regions (or the plurality of color conversion regions) may include a first region emitting first color light, a second region emitting second color light, and/or a third region emitting third color light, wherein the first color light, the second color light, and/or the third color light may have different maximum emission wavelengths from one another. For example, the first color light may be red light, the second color light may be green light, and the third color light may be blue light.

For example, the plurality of color filter regions (or the plurality of color conversion regions) may include quantum dots. In particular, the first region may include red quantum dots, the second region may include green quantum dots, and the third region may include blue quantum dots.

For details on the quantum dot, related descriptions provided herein may be referred to. The first region, the second region, and/or the third region may each include a scatterer.

For example, the light-emitting device may emit first light, the first region may absorb the first light to emit first-first color light, the second region may absorb the first light to emit second-first color light, and the third region may absorb the first light to emit third-first color light. In this regard, the first-first color light, the second-first color light, and the third-first color light may have different maximum emission wavelengths. In particular, the first light may be blue light, the first-first color light may be red light, the second-first color light may be green light, and the third-first color light may be blue light.

The electronic apparatus may further include a thin-film transistor, in addition to the light-emitting device as described herein. The thin-film transistor may include a source electrode, a drain electrode, and an activation layer, wherein any one of the source electrode and the drain electrode may be electrically connected to any one of the first electrode and the second electrode of the light-emitting device.

The thin-film transistor may further include a gate electrode, a gate insulating film, and/or the like.

The activation layer may include crystalline silicon, amorphous silicon, an organic semiconductor, an oxide semiconductor, and/or the like.

The electronic apparatus may further include a sealing portion for sealing the light-emitting device. The sealing portion may be located between the color filter and/or the color conversion layer and the light-emitting device. The sealing portion allows light from the light-emitting device to be extracted to the outside, and concurrently prevents ambient air and moisture from penetrating into the light-emitting device. The sealing portion may be a sealing substrate including a transparent glass substrate or a plastic substrate. The sealing portion may be a thin-film encapsulation layer including at least one layer of an organic layer and/or an inorganic layer. When the sealing portion is a thin film encapsulation layer, the electronic apparatus may be flexible.

One or more suitable functional layers may be additionally located on the sealing portion, in addition to the color filter and/or the color conversion layer, according to the utilize of the electronic apparatus. Examples of the functional layers may include a touch screen layer, a polarizing layer, and/or the like. The touch screen layer may be a pressure-sensitive touch screen layer, a capacitive touch screen layer, or an infrared touch screen layer. The authentication apparatus may be, for example, a biometric authentication apparatus that authenticates an individual by utilizing biometric information of a living body (for example, fingertips, pupils, and/or the like).

The authentication apparatus may further include, in addition to the light-emitting device as described herein, a biometric information collector.

The electronic apparatus may be applied to one or more suitable displays, light sources, lighting, personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram displays, ultrasonic diagnostic devices, or endoscope displays), fish finders, one or more suitable measuring instruments, meters (for example, meters for a vehicle, an aircraft, and a vessel), projectors, and/or the like.

## Optical member and apparatus

According to another aspect, an optical member may include the quantum dots described herein.

The optical member may be a color conversion member.

The color conversion member may include a substrate and a pattern layer formed on the substrate.

The substrate may be a substrate constituting the color conversion member, or may be a region of one or more suitable apparatuses (for example, a display apparatus) in which the color conversion member is located. The substrate may be glass, silicon (Si), silicon oxide (SiOx), and/or a polymer substrate, and the polymer substrate may be

polyethersulfone (PES) and/or polycarbonate (PC).

The pattern layer may include the thin-film quantum dot. For example, the pattern layer may be a thin-film quantum dot.

The color conversion member including the substrate and the pattern layer may further include a partition wall or a black matrix formed between pattern layers. Meanwhile, the color conversion member may further include a color filter to further improve light conversion efficiency.

The color conversion member may include a red pattern layer capable of emitting red light, a green pattern layer capable of emitting green light, a blue pattern layer capable of emitting blue light, or a combination thereof. The red pattern layer, the green pattern layer, and/or the blue pattern layer may be implemented by controlling the component, composition, and/or structure of the quantum dot.

According to another aspect, an apparatus may include the quantum dots (or an optical member including the quantum dots).

The apparatus may further include a light source, and the quantum dots (or an optical member including the quantum dots) may be located in the path of light emitted from the light source.

The light source may emit blue light, red light, green light, or white light. For example, the light source may emit blue light. Additionally, light emitted from the light source may be absorbed by the quantum dots.

The light source may be an organic light-emitting device (OLED) or a light-emitting diode (LED).

Light emitted from the light source as described herein may be photoconverted by the quantum dots while passing through the quantum dots. Accordingly, due to the quantum dots, light having a wavelength that is different from that of the light emitted from the light source, may be emitted.

For example, the quantum dot may absorb and convert light emitted from the light source and emit light having a maximum emission wavelength in a range of about 480 nm to about 530 nm.

The apparatus may be a display apparatus, a lighting apparatus, and/or the like.

Description of FIGS. 2 and 3

FIG. 2 is a schematic cross-sectional view showing a light-emitting apparatus according to an embodiment.

The light-emitting apparatus of FIG. 2 includes a substrate 100, a thin-film transistor (TFT), a light-emitting device, and an encapsulation portion 300 that seals the light-emitting device.

The substrate 100 may be a flexible substrate, a glass substrate, or a metal substrate. A buffer layer 210 may be located on the substrate 100. The buffer layer 210 may prevent or reduce penetration of impurities through the substrate 100 and may provide a flat surface on the substrate 100.

A TFT may be located on the buffer layer 210. The TFT may include an activation layer 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region, and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 and between the gate electrode 240 and the drain electrode 270, to insulate from one another.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located in contact with the exposed portions of the source region and the drain region of the activation layer 220.

The TFT is electrically connected to a light-emitting device to drive the light-emitting device, and is covered and protected by a passivation layer 280. The passivation layer 280 may include an inorganic insulating film, an organic insulating film, or a combination thereof. A light-emitting device is provided on the passivation layer 280. The light-emitting device may include a first electrode 110, an interlayer 130, and a second electrode 150.

The first electrode 110 may be located on the passivation layer 280. The passivation layer 280 may be located to expose a portion of the drain electrode 270, not fully covering the drain electrode 270, and the first electrode 110 may be located to be connected to the exposed portion of the drain electrode 270.

A pixel defining layer 290 including an insulating material may be located on the first electrode 110. The pixel defining layer 290 may expose a certain region of the first electrode 110, and an interlayer 130 may be formed in the exposed region of the first electrode 110. The pixel defining layer 290 may be a polyimide or polyacrylic organic film. Although not shown in FIG. 2, at least some layers of the interlayer 130 may extend beyond the upper portion of the pixel defining layer 290 to be located in the form of a common layer.

The second electrode 150 may be located on the interlayer 130, and a capping layer 170 may be additionally

formed on the second electrode 150. The capping layer 170 may be formed to cover the second electrode 150.

The encapsulation portion 300 may be located on the capping layer 170. The encapsulation portion 300 may be located on a light-emitting device to protect the light-emitting device from moisture and/or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate, polyacrylic acid, and/or the like), an epoxy-based resin (for example, aliphatic glycidyl ether (AGE), and/or the like), or a combination thereof; or a combination of the inorganic film and the organic film.

FIG. 3 shows a cross-sectional view showing a light-emitting apparatus according to another embodiment.

The light-emitting apparatus of FIG. 3 is the same as the light-emitting apparatus of FIG. 1, except that a light-shielding pattern 500 and a functional region 400 are additionally provided on the encapsulation portion 300. The functional region 400 may be i) a color filter region, ii) a color conversion region, or iii) a combination of the color filter region and the color conversion region. According to an embodiment, the light-emitting device included in the light-emitting apparatus of FIG. 2 may be a tandem light-emitting device.

Manufacturing method

Respective layers included in the hole transport region, the emission layer, and respective layers included in the electron transport region may be formed in a certain region by utilizing one or more suitable methods selected from vacuum deposition, spin coating, casting, Langmuir-Blodgett (LB) deposition, ink-jet printing, laser-printing, and/or laser-induced thermal imaging (LITI).

When layers constituting the hole transport region, an emission layer, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 angstrom per second (Å/sec) to about 100 Å/sec, depending on a material to be included in a layer to be formed and the structure of a layer to be formed.

Definition of terms

The term "$C_3$-$C_{60}$ carbocyclic group" as utilized herein refers to a cyclic group consisting of carbon only as a ring-forming atom and having three to sixty carbon atoms, and the term "$C_1$-$C_{60}$ heterocyclic group" as utilized herein refers to a cyclic group that has one to sixty carbon atoms and further has, in addition to carbon, a heteroatom as a ring-forming atom. The $C_3$-$C_{60}$ carbocyclic group and the $C_1$-$C_{60}$ heterocyclic group may each be a monocyclic group consisting of one ring or a polycyclic group in which two or more rings are condensed with each other. For example, the $C_1$-$C_{60}$ heterocyclic group has 3 to 61 ring-forming atoms.

The "cyclic group" as utilized herein may include the $C_3$-$C_{60}$ carbocyclic group, and the $C_1$-$C_{60}$ heterocyclic group.

The term "$\pi$ electron-rich $C_3$-$C_{60}$ cyclic group" as utilized herein refers to a cyclic group that has three to sixty carbon atoms and does not include *-N=*' as a ring-forming moiety, and the term "$\pi$ electron-deficient nitrogen-containing $C_1$-$C_{60}$ cyclic group" as utilized herein refers to a heterocyclic group that has one to sixty carbon atoms and includes *-N=*' as a ring-forming moiety.

For example,

the $C_3$-$C_{60}$ carbocyclic group may be i) Group T1 or ii) a condensed cyclic group in which two or more of Group T1 are condensed with each other (for example, a cyclopentadiene group, an adamantane group, a norbornane group, a benzene group, a pentalene group, a naphthalene group, an azulene group, an indacene group, an acenaphthylene group, a phenalene group, a phenanthrene group, an anthracene group, a fluoranthene group, a triphenylene group, a pyrene group, a chrysene group, a perylene group, a pentaphene group, a heptalene group, a naphthacene group, a picene group, a hexacene group, a pentacene group, a rubicene group, a coronene group, an ovalene group, an indene group, a fluorene group, a spiro-bifluorene group, a benzofluorene group, an indenophenanthrene group, or an indenoanthracene group),

the $C_1$-$C_{60}$ heterocyclic group may be i) Group T2, ii) a condensed cyclic group in which two or more of Group T2 are condensed with each other, or iii) a condensed cyclic group in which at least one Group T2 and at least one Group T1 are condensed with each other (for example, a pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a

benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

the $\pi$ electron-rich $C_3$-$C_{60}$ cyclic group may be i) Group T1, ii) a condensed cyclic group in which two or more of Group T1 are condensed with each other, iii) Group T3, iv) a condensed cyclic group in which two or more of Group T3 are condensed with each other, or v) a condensed cyclic group in which at least one Group T3 and at least one Group T1 are condensed with each other (for example, the $C_3$-$C_{60}$ carbocyclic group, a 1H-pyrrole group, a silole group, a borole group, a 2H-pyrrole group, a 3H-pyrrole group, a thiophene group, a furan group, an indole group, a benzoindole group, a naphthoindole group, an isoindole group, a benzoisoindole group, a naphthoisoindole group, a benzosilole group, a benzothiophene group, a benzofuran group, a carbazole group, a dibenzosilole group, a dibenzothiophene group, a dibenzofuran group, an indenocarbazole group, an indolocarbazole group, a benzofurocarbazole group, a benzothienocarbazole group, a benzosilolocarbazole group, a benzoindolocarbazole group, a benzocarbazole group, a benzonaphthofuran group, a benzonaphthothiophene group, a benzonaphthosilole group, a benzofurodibenzofuran group, a benzofurodibenzothiophene group, a benzothienodibenzothiophene group, and/or the like),

the $\pi$ electron-deficient nitrogen-containing $C_1$-$C_{60}$ cyclic group may be i) a Group T4, ii) a condensed cyclic group in which two or more of Group T4 are condensed with each other, iii) a condensed cyclic group in which at least one Group T4 group and at least one Group T1 are condensed with each other, iv) a condensed cyclic group in which at least one Group T4 and at least one Group T3 are condensed with each other, or v) a condensed cyclic group in which at least one Group T4, at least one Group T1, and at least one Group T3 are condensed with one another (for example, a pyrazole group, an imidazole group, a triazole group, an oxazole group, an isoxazole group, an oxadiazole group, a thiazole group, an isothiazole group, a thiadiazole group, a benzopyrazole group, a benzimidazole group, a benzoxazole group, a benzoisoxazole group, a benzothiazole group, a benzoisothiazole group, a pyridine group, a pyrimidine group, a pyrazine group, a pyridazine group, a triazine group, a quinoline group, an isoquinoline group, a benzoquinoline group, a benzoisoquinoline group, a quinoxaline group, a benzoquinoxaline group, a quinazoline group, a benzoquinazoline group, a phenanthroline group, a cinnoline group, a phthalazine group, a naphthyridine group, an imidazopyridine group, an imidazopyrimidine group, an imidazotriazine group, an imidazopyrazine group, an imidazopyridazine group, an azacarbazole group, an azafluorene group, an azadibenzosilole group, an azadibenzothiophene group, an azadibenzofuran group, and/or the like),

Group T1 may be a cyclopropane group, a cyclobutane group, a cyclopentane group, a cyclohexane group, a cycloheptane group, a cyclooctane group, a cyclobutene group, a cyclopentene group, a cyclopentadiene group, a cyclohexene group, a cyclohexadiene group, a cycloheptene group, an adamantane group, a norbornane (or a bicyclo[2.2.1]heptane) group, a norbornene group, a bicyclo[1.1.1]pentane group, a bicyclo[2.1.1]hexane group, a bicyclo[2.2.2]octane group, or a benzene group,

Group T2 may be a furan group, a thiophene group, a 1H-pyrrole group, a silole group, a borole group, a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, a tetrazine group, a pyrrolidine group, an imidazolidine group, a dihydropyrrole group, a piperidine group, a tetrahydropyridine group, a dihydropyridine group, a hexahydropyrimidine group, a tetrahydropyrimidine group, a dihydropyrimidine group, a piperazine group, a tetrahydropyrazine group, a dihydropyrazine group, a tetrahydropyridazine group, or a dihydropyridazine group,

Group T3 may be a furan group, a thiophene group, a 1H-pyrrole group, a silole group, or a borole group, and

Group T4 group may be a 2H-pyrrole group, a 3H-pyrrole group, an imidazole group, a pyrazole group, a triazole group, a tetrazole group, an oxazole group, an isoxazole group, an oxadiazole group, a thiazole group, an isothiazole group, a thiadiazole group, an azasilole group, an azaborole group, a pyridine group, a pyrimidine group, a pyrazine group, a pyridazine group, a triazine group, or a tetrazine group.

The terms "the cyclic group, the $C_3$-$C_{60}$ carbocyclic group, the $C_1$-$C_{60}$ heterocyclic group, the $\pi$ electron-rich $C_3$-$C_{60}$ cyclic group, or the $\pi$ electron-deficient nitrogen-containing $C_1$-$C_{60}$ cyclic group" as utilized herein refer to a group condensed to any cyclic group, a monovalent group, or a polyvalent group (for example, a divalent group, a trivalent group,

a tetravalent group, and/or the like) according to the structure of a formula for which the corresponding term is utilized. For example, the "benzene group" may be a benzo group, a phenyl group, a phenylene group, and/or the like, which may be easily understood by one of ordinary skill in the art according to the structure of a formula including the "benzene group."

Examples of the monovalent $C_3$-$C_{60}$ carbocyclic group and the monovalent $C_1$-$C_{60}$ heterocyclic group are a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_1$-$C_{60}$ heteroaryl group, a monovalent non-aromatic condensed polycyclic group, and a monovalent non-aromatic condensed heteropolycyclic group. Examples of the divalent $C_3$-$C_{60}$ carbocyclic group and the monovalent $C_1$-$C_{60}$ heterocyclic group are a $C_3$-$C_{10}$ cycloalkylene group, a $C_1$-$C_{10}$ heterocycloalkylene group, a $C_3$-$C_{10}$ cycloalkenylene group, a $C_1$-$C_{10}$ heterocycloalkenylene group, a $C_6$-$C_{60}$ arylene group, a $C_1$-$C_{60}$ heteroarylene group, a divalent non-aromatic condensed polycyclic group, and a substituted or unsubstituted divalent non-aromatic condensed heteropolycyclic group.

The term "$C_1$-$C_{60}$ alkyl group" as utilized herein refers to a linear or branched aliphatic hydrocarbon monovalent group that has one to sixty carbon atoms, and specific examples thereof are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, and a tert-decyl group. The term "$C_1$-$C_{60}$ alkylene group" as utilized herein refers to a divalent group having the same structure as the $C_1$-$C_{60}$ alkyl group.

The term "$C_2$-$C_{60}$ alkenyl group" as utilized herein refers to a monovalent hydrocarbon group having at least one carbon-carbon double bond in the middle or at the terminus of the $C_2$-$C_{60}$ alkyl group, and examples thereof are an ethenyl group, a propenyl group, and a butenyl group. The term "$C_2$-$C_{60}$ alkenylene group" as utilized herein refers to a divalent group having the same structure as the $C_2$-$C_{60}$ alkenyl group.

The term "$C_2$-$C_{60}$ alkynyl group" as utilized herein refers to a monovalent hydrocarbon group having at least one carbon-carbon triple bond in the middle or at the terminus of the $C_2$-$C_{60}$ alkyl group, and examples thereof include an ethynyl group, a propynyl group, and/or the like. The term "$C_2$-$C_{60}$ alkynylene group" as utilized herein refers to a divalent group having the same structure as the $C_2$-$C_{60}$ alkynyl group.

The term "$C_1$-$C_{60}$ alkoxy group" as utilized herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group.

The term "$C_3$-$C_{10}$ cycloalkyl group" as utilized herein refers to a monovalent saturated hydrocarbon cyclic group having 3 to 10 carbon atoms, and examples thereof are a cyclopropyl group, a cyclobutyl group, a cyclopentyl group, a cyclohexyl group, a cycloheptyl group, a cyclooctyl group, an adamantanyl group, a norbornanyl group (or bicyclo[2.2.1]heptyl group), a bicyclo[1.1.1]pentyl group, a bicyclo[2.1.1]hexyl group, and a bicyclo[2.2.2]octyl group. The term "$C_3$-$C_{10}$ cycloalkylene group" as utilized herein refers to a divalent group having the same structure as the $C_3$-$C_{10}$ cycloalkyl group.

The term "$C_1$-$C_{10}$ heterocycloalkyl group" as utilized herein refers to a monovalent cyclic group of 1 to 10 carbon atoms, further including, in addition to carbon atoms, at least one heteroatom, as ring-forming atoms, and specific examples are a 1,2,3,4-oxatriazolidinyl group, a tetrahydrofuranyl group, and a tetrahydrothiophenyl group. The term "$C_1$-$C_{10}$ heterocycloalkylene group" as utilized herein refers to a divalent group having the same structure as the $C_1$-$C_{10}$ heterocycloalkyl group.

The term $C_3$-$C_{10}$ cycloalkenyl group utilized herein refers to a monovalent cyclic group that has three to ten carbon atoms and at least one carbon-carbon double bond in the ring thereof and no aromaticity, and specific examples thereof are a cyclopentenyl group, a cyclohexenyl group, and a cycloheptenyl group. The term "$C_3$-$C_{10}$ cycloalkenylene group" as utilized herein refers to a divalent group having the same structure as the $C_3$-$C_{10}$ cycloalkenyl group.

The term "$C_1$-$C_{10}$ heterocycloalkenyl group" as utilized herein refers to a monovalent cyclic group of 1 to 10 carbon atoms, further including, in addition to carbon atoms, at least one heteroatom, as ring-forming atoms, and having at least one carbon-carbon double bond in the cyclic structure thereof. Examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as utilized herein refers to a divalent group having the same structure as the $C_1$-$C_{10}$ heterocycloalkenyl group.

The term "$C_6$-$C_{60}$ aryl group" as utilized herein refers to a monovalent group having a carbocyclic aromatic system of 6 to 60 carbon atoms, and the term "$C_6$-$C_{60}$ arylene group" as utilized herein refers to a divalent group having a carbocyclic aromatic system of 6 to 60 carbon atoms. Examples of the $C_6$-$C_{60}$ aryl group are a phenyl group, a pentalenyl group, a naphthyl group, an azulenyl group, an indacenyl group, an acenaphthyl group, a phenalenyl group, a phenanthrenyl group, an anthracenyl group, a fluoranthenyl group, a triphenylenyl group, a pyrenyl group, a chrysenyl group, a perylenyl group, a pentaphenyl group, a heptalenyl group, a naphthacenyl group, a picenyl group, a hexacenyl group, a pentacenyl group, a rubicenyl group, a coronenyl group, and an ovalenyl group. When the $C_6$-$C_{60}$ aryl group and

the $C_6$-$C_{60}$ arylene group each include two or more rings, the rings may be condensed with each other.

The term "$C_1$-$C_{60}$ heteroaryl group" as utilized herein refers to a monovalent group having a heterocyclic aromatic system of 1 to 60 carbon atoms, further including, in addition to carbon atoms, at least one heteroatom, as ring-forming atoms. The term "$C_1$-$C_{60}$ heteroarylene group" as utilized herein refers to a divalent group having a heterocyclic aromatic system of 1 to 60 carbon atoms, further including, in addition to carbon atoms, at least one heteroatom, as ring-forming atoms. Examples of the $C_1$-$C_{60}$ heteroaryl group are a pyridinyl group, a pyrimidinyl group, a pyrazinyl group, a pyridazinyl group, a triazinyl group, a quinolinyl group, a benzoquinolinyl group, an isoquinolinyl group, a benzoisoquinolinyl group, a quinoxalinyl group, a benzoquinoxalinyl group, a quinazolinyl group, a benzoquinazolinyl group, a cinnolinyl group, a phenanthrolinyl group, a phthalazinyl group, and a naphthyridinyl group. When the $C_1$-$C_{60}$ heteroaryl group and the $C_1$-$C_{60}$ heteroarylene group each include two or more rings, the rings may be condensed with each other.

The term "monovalent non-aromatic condensed polycyclic group" as utilized herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group are an indenyl group, a fluorenyl group, a spiro-bifluorenyl group, a benzofluorenyl group, an indenophenanthrenyl group, and an indeno anthracenyl group. The term "divalent non-aromatic condensed polycyclic group" as utilized herein refers to a divalent group having the same structure as the monovalent non-aromatic condensed polycyclic group described herein.

The term "monovalent non-aromatic condensed heteropolycyclic group" as utilized herein refers to a monovalent group (for example, having 1 to 60 carbon atoms) having two or more rings condensed to each other, further including, in addition to carbon atoms, at least one heteroatom, as ring-forming atoms, and having non-aromaticity in its entire molecular structure. Examples of the monovalent non-aromatic condensed heteropolycyclic group are a pyrrolyl group, a thiophenyl group, a furanyl group, an indolyl group, a benzoindolyl group, a naphthoindolyl group, an isoindolyl group, a benzoisoindolyl group, a naphthoisoindolyl group, a benzosilolyl group, a benzothiophenyl group, a benzofuranyl group, a carbazolyl group, a dibenzosilolyl group, a dibenzothiophenyl group, a dibenzofuranyl group, an azacarbazolyl group, an azafluorenyl group, an azadibenzosilolyl group, an azadibenzothiophenyl group, an azadibenzofuranyl group, a pyrazolyl group, an imidazolyl group, a triazolyl group, a tetrazolyl group, an oxazolyl group, an isoxazolyl group, a thiazolyl group, an isothiazolyl group, an oxadiazolyl group, a thiadiazolyl group, a benzopyrazolyl group, a benzimidazolyl group, a benzoxazolyl group, a benzothiazolyl group, a benzoxadiazolyl group, a benzothiadiazolyl group, an imidazopyridinyl group, an imidazopyrimidinyl group, an imidazotriazinyl group, an imidazopyrazinyl group, an imidazopyridazinyl group, an indeno carbazolyl group, an indolocarbazolyl group, a benzofurocarbazolyl group, a benzothienocarbazolyl group, a benzosilolocarbazolyl group, a benzoindolocarbazolyl group, a benzocarbazolyl group, a benzonaphthofuranyl group, a benzonaphthothiophenyl group, a benzonaphthosilolyl group, a benzofurodibenzofuranyl group, a benzofurodibenzothiophenyl group, and a benzothienodibenzothiophenyl group. The term "divalent non-aromatic condensed heteropolycyclic group" as utilized herein refers to a divalent group having the same structure as the monovalent non-aromatic condensed heteropolycyclic group described herein.

The term "$C_6$-$C_{60}$ aryloxy group" as utilized herein indicates $-OA_{102}$ (wherein $A_{102}$ is a $C_6$-$C_{60}$ aryl group), and the term "$C_6$-$C_{60}$ arylthio group" as utilized herein indicates$-SA_{103}$ (wherein $A_{103}$ is a $C_6$-$C_{60}$ aryl group).

The term "$C_7$-$C_{60}$ arylalkyl group" utilized herein refers to $-A_{104}A_{105}$ (where $A_{104}$ may be a $C_1$-$C_{54}$ alkylene group, and $A_{105}$ may be a $C_6$-$C_{59}$ aryl group), and the term $C_2$-$C_{60}$ heteroarylalkyl group" utilized herein refers to $-A_{106}A_{107}$ (where $A_{106}$ may be a $C_1$-$C_{59}$ alkylene group, and $A_{107}$ may be a $C_1$-$C_{59}$ heteroaryl group).

The term "$R_{10a}$" as utilized herein refers to:

deuterium, -F, -Cl, -Br, -I, a hydroxyl group, a cyano group, or a nitro group,

a $C_1$-$C_{60}$ alkyl group, a $C_2$-$C_{60}$ alkenyl group, a $C_2$-$C_{60}$ alkynyl group, or a $C_1$-$C_{60}$ alkoxy group, each unsubstituted or substituted with deuterium, -F, -Cl, -Br, -I, a hydroxyl group, a cyano group, a nitro group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, $-P(=O)(Q_{11})(Q_{12})$, or a combination thereof,

a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, or a $C_2$-$C_{60}$ heteroarylalkyl group, each unsubstituted or substituted with deuterium, -F, -Cl, -Br, -I, a hydroxyl group, a cyano group, a nitro group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{60}$ carbocyclic group, a $C_1$-$C_{60}$ heterocyclic group, a $C_6$-$C_{60}$ aryloxy group, a $C_6$-$C_{60}$ arylthio group, a $C_7$-$C_{60}$ arylalkyl group, a $C_2$-$C_{60}$ heteroarylalkyl group, $-Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, $-P(=O)(Q_{21})(Q_{22})$, or a combination thereof; or

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, or

$-P(=O)(Q_{31})(Q_{32})$,

$Q_1$ to $Q_3$, $Q_{11}$ to $Q_{13}$, $Q_{21}$ to $Q_{23}$ and $Q_{31}$ to $Q_{33}$ utilized herein may each independently be: hydrogen; deuterium; -F; -Cl; -Br; -I; a hydroxyl group; a cyano group; a nitro group; a $C_1$-$C_{60}$ alkyl group; a $C_2$-$C_{60}$ alkenyl group; a $C_2$-$C_{60}$

alkynyl group; a $C_1$-$C_{60}$ alkoxy group; a $C_3$-$C_{60}$ carbocyclic group or a $C_1$-$C_{60}$ heterocyclic group, each unsubstituted or substituted with deuterium, -F, a cyano group, a $C_1$-$C_{60}$ alkyl group, a $C_1$-$C_{60}$ alkoxy group, a phenyl group, a biphenyl group, or a combination thereof; a $C_7$-$C_{60}$ arylalkyl group; or a $C_2$-$C_{60}$ heteroarylalkyl group.

The term "heteroatom" as utilized herein refers to any atom other than a carbon atom. Examples of the heteroatom are O, S, N, P, Si, B, Ge, Se, and a combinations thereof.

The term "third-row transition metal" utilized herein includes hafnium (Hf), tantalum (Ta), tungsten (W), rhenium (Re), osmium (Os), iridium (Ir), platinum (Pt), gold (Au), and/or the like.

"Ph" as utilized herein refers to a phenyl group, "Me" as utilized herein refers to a methyl group, "Et" as utilized herein refers to an ethyl group, "ter-Bu" or "But" as utilized herein refers to a tert-butyl group, and "OMe" as utilized herein refers to a methoxy group.

The term "biphenyl group" as utilized herein refers to "a phenyl group substituted with a phenyl group." In other words, the "biphenyl group" is a substituted phenyl group having a $C_6$-$C_{60}$ aryl group as a substituent.

The term "terphenyl group" as utilized herein refers to "a phenyl group substituted with a biphenyl group." In other words, the "terphenyl group" is a substituted phenyl group having, as a substituent, a $C_6$-$C_{60}$ aryl group substituted with a $C_6$-$C_{60}$ aryl group.

**[0264]** * and *' as utilized herein, unless defined otherwise, each refer to a binding site to a neighboring atom in a corresponding formula or moiety.

Hereinafter, compounds according to an embodiment and light-emitting devices according to an embodiment will be described in more detail with reference to the following synthesis examples and examples. The wording "B was utilized instead of A" utilized in describing Synthesis Examples refers to that an identical molar equivalent of B was utilized in place of A.

Examples and Evaluation Examples

Example 1

The materials 0.2 mmol of CuI, 0.5 mmol of $GaI_3$, 0.4 mmol of InI, 0.85 mmol of trioctylphosphine oxide (TOPO), 5 mL of oleylamine, and 5 mL of trioctylamine were added to a first flask, and the flask was connected to a schlenk tube. A first mixture in the first flask was vacuum-treated at 120 °C for 30 minutes. 1 M of sulfur-in-oleylamine (S-OLA) solution was prepared in a second flask. The second flask was vacuum-treated at 120 °C for 20 minutes and stored in a nitrogen atmosphere. After the first flask was vacuum-treated, 1.6 mL of 1 M S-OLA and 0.9 mL of dodecanethiol (DDT) were quickly added to the first flask at 120 °C to form a second mixture. Then, the internal temperature of the first flask was raised to 220 °C, and the reaction of the components therein was maintained for 4 hours. After the reaction was terminated, the first flask was cooled to room temperature, and the second mixture was purified with ethanol to manufacture copper indium gallium disulfide (CIGS) core 1.

Regarding gallium and indium included in CIGS core 1, the value of Ga/(In+Ga) was 0.56.

Example 2

CIGS core 2 was manufactured in substantially the same manner as in Example 1, except that the amount of the gallium precursor and the indium precursor was adjusted so that the value of Ga/(In+Ga) was 0.67.

Example 3

CIGS core 3 was manufactured in substantially the same manner as in Example 1, except that the amount of the gallium precursor and the indium precursor was adjusted so that the value of Ga/(In+Ga) was 0.78.

Example 4

CIGS core 1 was re-dispersed in a third flask including toluene, and 8 mL of oleylamine was added to the third flask to form a fourth mixture. The fourth mixture was vacuum-treated at 120 °C for 10 minutes. A toluene solution in which 1.2 mL of S-OLA and 1.7 mmol of $GaCl_3$ were dispersed was added to the third flask to form a fifth mixture. The third flask was heated to 240 °C, and the reaction of the components therein was maintained for 2 hours. After the reaction was terminated, the third flask was cooled to 200 °C. Then, 0.5 mL of octanethiol and 0.5 mL of trioctylphosphine (TOP) were added to the third flask. The third flask was cooled to room temperature to synthesize quantum dot (QD) 1 including the CIGS core 1 and a GaS shell.

Example 5

QD 2 including the CIGS core 1 and a ZnS shell was manufactured in substantially the same manner as in Example 1, except that 1.7 mmol of $ZnCl_2$ was utilized instead of 1.7 mmol of $GaCl_3$.

Comparative Example 1

CIGS core 4 was manufactured in substantially the same manner as in Example 1, except that 0.9 mL of dodecanethiol was not utilized.

Comparative Example 2

CIGS core 4 was manufactured in substantially the same manner as in Example 1, except that 1 M of S-OLA was not utilized.

Evaluation Example 1: Evaluation of photoluminescence (PL) spectrum of quantum dot

The value of Ga/(In+Ga), the luminescence peak wavelength, and the full width at half maximum (FWHM) of the cores and the QDs manufactured according to the Examples were evaluated by utilizing UV/ViS spectroscopy and PL. The value of Ga/(In+Ga) was evaluated based on the core.

Table 1

| | Emission peak wavelength (nm) | FWHM (nm) | Ga/(In+Ga) |
|---|---|---|---|
| Example 1 | 588 | 71 | 0.56 |
| Example 2 | 575 | 79 | 0.67 |
| Example 3 | 555 | 99 | 0.78 |
| Example 4 | 511 | 56 | 0.56 |
| Example 5 | 599 | 135 | 0.56 |
| Comparative Example 1 | Non-emission | Non-emission | 0.56 |
| Comparative Example 2 | Non-emission | Non-emission | 0.56 |

Referring to Table 1, unlike the CIGS cores of Comparative Example 1 and Comparative Example 2, all of the CIGS cores and QDs obtained according to the Examples emitted light. In addition, QD 1 of Example 4 may be to emit light having a shorter wavelength than that of Examples 1 to 3, and the FWHM was found to be less than 60 nm.

Evaluation Example 2: Evaluation of gallium amount

The gallium amount (e.g., content) of Examples 1 and 4 were evaluated by utilizing an inductively coupled plasma (ICP) optical emission spectrometry. The molar ratio of gallium included in the CIGS core 1 of Example 1 was evaluated to be about 0.2. The molar ratio of gallium included in QD 1 of Example 4 was evaluated to be about 0.29.

## Claims

**1.** A quantum dot comprising:

a core comprising a Group I-III-VI compound; and
a shell covering the core,
wherein the shell comprises a Group II-VI compound or a Group III-VI compound, and,
regarding the core and the shell, a molar ratio of a Group III element in the core to the Group III element in the shell is 0.2 to 0.6.

**2.** The quantum dot of claim 1, wherein the Group I-III-VI compound is represented by Formula 1:

Formula 1 $M^1_aM^2_bM^3_cM^4_2$,

wherein, in Formula 1,

$M^1$ is a Group I metal element, $M^2$ and $M^3$ are each independently a Group III metal element, and $M^4$ is a Group VI element,
a, b, and c are each independently 0 to 1, and
a sum of b and c is from 0 to 1.

**3.** The quantum dot of claim 2, wherein a sum of a, b, and c is 2.

**4.** The quantum dot of claim 2, wherein $M^1$ is copper (Cu).

**5.** The quantum dot of claim 2, wherein $M^2$ is gallium (Ga), and $M^2$ is indium (In).

**6.** The quantum dot of claim 2, wherein $M^4$ is oxygen (O) or sulfur (S).

**7.** The quantum dot of claim 2, wherein b/c is from 0.05 to 20.

**8.** The quantum dot of claim 1, wherein the Group II-VI compound comprises at least one selected from among CdS, CdSe, CdTe, ZnS, ZnSe, ZnTe, ZnO, HgS, HgSe, and HgTe.

**9.** The quantum dot of claim 1, wherein the Group III-VI compound comprises at least one selected from among $In_2S_3$, $In_2Se_3$, $Ga_2S_3$, $Ga_2Se_3$, $InGaS_3$, and $InGaSe_3$.

**10.** The quantum dot of claim 1, wherein, regarding a sum of a Group I element and the Group III element in the core, a molar ratio of a Group II element or the Group III element in the shell to the sum of the Group I element and the Group III element in the core is from 1 to 10.

**11.** The quantum dot of claim 1, wherein a full width at half maximum of a photoluminescence peak is about 140 nanometer (nm) or less.

**12.** The quantum dot of claim 1, wherein the quantum dot is configured to emit blue light or green light.

**13.** A method of manufacturing a quantum dot, the method comprising:

forming a first mixture comprising a first material comprising a Group I element, a second material comprising a Group III element, a third material comprising a Group III element, and a first ligand precursor;
forming a second mixture by mixing the first mixture and a fourth material comprising a Group VI element;
forming a third mixture comprising a core from the second mixture;
forming a fourth mixture by mixing the third mixture and a second ligand precursor;
forming a fifth mixture by adding a fifth material comprising a Group IV element and a sixth material comprising a Group III element to the fourth mixture or by adding a fifth material comprising a Group IV element and a seventh material comprising a Group II element to the fourth mixture; and
forming a sixth mixture comprising a quantum dot comprising a core and a shell from the fifth mixture.

**14.** The method of claim 13, wherein the first material comprises copper (Cu).

**15.** The method of claim 13, wherein the method satisfies at least one of Conditions i) to iii):

i) the second material and the sixth material each comprise gallium (Ga);
ii) the third material comprises indium (In); and
iii) the fourth material and the fifth material each comprise sulfur (S).

**16.** The method of claim 15, wherein the fourth material comprises atomic S and a thiol-based compound.

**17.** The method of claim 13, wherein the method satisfies at least one of Conditions iv) and v):

iv) the first ligand precursor comprises at least one selected from among a primary amine, a secondary amine, a tertiary amine, and a phosphine oxide; and
v) the second ligand precursor comprises a primary amine.

**18.** The method of claim 13, wherein the forming of the third mixture and the forming of the sixth mixture are each independently performed at about 240 °C to about 300 °C.

**19.** A light-emitting device comprising:

a first electrode;
a second electrode facing the first electrode; and
an emission layer between the first electrode and the second electrode, wherein
the emission layer comprises the quantum dot of any one of claims 1 to 12.

**20.** An apparatus comprising:

an optical member; and
a light source,
wherein,
the optical member comprises at least one region that comprises the quantum dot of any one of claims 1 to 12, and the at least one region is configured to absorb light emitted from the light source.

FIG. 1

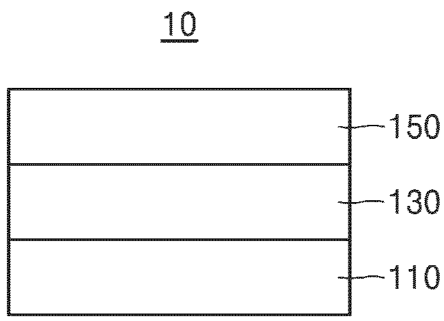

FIG. 2

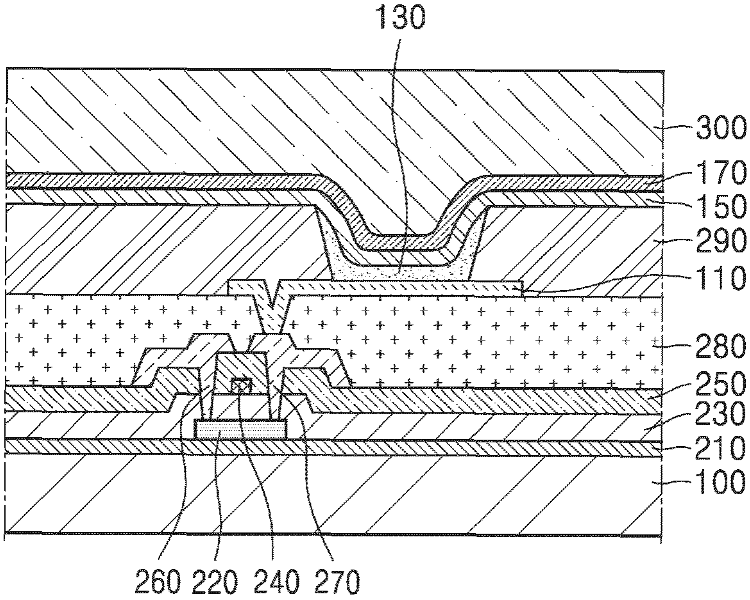

FIG. 3

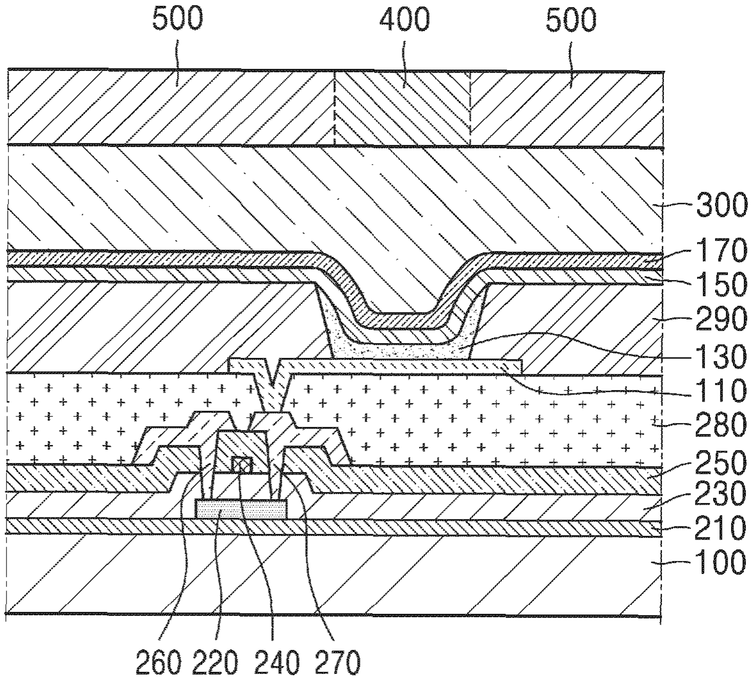
500
400
500
300
170
150
290
130
110
280
250
230
210
100
260 220 240 270

## INTERNATIONAL SEARCH REPORT

International application No.
**PCT/KR2024/000918**

**A. CLASSIFICATION OF SUBJECT MATTER**

**C09K 11/62**(2006.01)i; **C09K 11/88**(2006.01)i; **H10K 50/115**(2023.01)i; **H01L 33/50**(2010.01)i

According to International Patent Classification (IPC) or to both national classification and IPC

**B. FIELDS SEARCHED**

Minimum documentation searched (classification system followed by classification symbols)

C09K 11/62(2006.01); H01L 27/32(2006.01); H01L 33/00(2010.01); H01L 33/06(2010.01); H01L 33/42(2010.01); H01L 51/00(2006.01); H01L 51/50(2006.01); H05B 33/14(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 양자점(quantum dot), 코어(core), 쉘(shell), I-III-VI족 화합물(I-III-VI group compound), II-VI족 화합물(II-VI group compound), III-VI족 화합물(III-VI group compound), 발광층(light emitting layer), 발광 소자(light emitting device)

**C. DOCUMENTS CONSIDERED TO BE RELEVANT**

| Category* | Citation of document, with indication, where appropriate, of the relevant passages | Relevant to claim No. |
|---|---|---|
| X | JP 2021-118161 A (NIPPON HOSO KYOKAI <NHK> et al.) 10 August 2021 (2021-08-10) See claims 1, 2 and 4; paragraphs [0012], [0022], [0030], [0031], [0050], [0052], [0053], [0055], [0057]-[0059] and [0061]; and examples 1 and 2. | 1,10-20 |
| Y | | 2-9 |
| Y | KR 10-2021-0070464 A (SAMSUNG DISPLAY CO., LTD.) 15 June 2021 (2021-06-15) See paragraphs [0063], [0067] and [0068]. | 2-9 |
| Y | KR 10-2021-0051998 A (SAMSUNG ELECTRONICS CO., LTD.) 10 May 2021 (2021-05-10) See claims 1, 4 and 5; and paragraphs [0005], [0085] and [0087]-[0089]. | 2-9 |
| Y | KR 10-2021-0039532 A (SAMSUNG DISPLAY CO., LTD.) 12 April 2021 (2021-04-12) See claims 1, 9, 11, 12 and 20; and paragraphs [0172] and [0173]. | 2-9 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 April 2024** | **24 April 2024** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

INTERNATIONAL SEARCH REPORT

International application No.
PCT/KR2024/000918

C. DOCUMENTS CONSIDERED TO BE RELEVANT

| Category* | Citation of document, with indication, where appropriate, of the relevant passages | Relevant to claim No. |
|---|---|---|
| Y | KR 10-2020-0041712 A (SAMSUNG ELECTRONICS CO., LTD.) 22 April 2020 (2020-04-22) See claims 1, 9, 10 and 31; and paragraphs [0099]-[0103]. | 2-9 |

Form PCT/ISA/210 (second sheet) (July 2022)

**INTERNATIONAL SEARCH REPORT**
**Information on patent family members**

International application No.
**PCT/KR2024/000918**

| Patent document cited in search report | Publication date (day/month/year) | Patent family member(s) | Publication date (day/month/year) |
|---|---|---|---|
| JP 2021-118161 A | 10 August 2021 | None | |
| KR 10-2021-0070464 A | 15 June 2021 | None | |
| KR 10-2021-0051998 A | 10 May 2021 | US 11482686 B2 | 25 October 2022 |
| | | US 11706936 B2 | 18 July 2023 |
| | | US 2021-0135138 A1 | 06 May 2021 |
| | | US 2023-0075189 A1 | 09 March 2023 |
| KR 10-2021-0039532 A | 12 April 2021 | None | |
| KR 10-2020-0041712 A | 22 April 2020 | KR 10-2581900 B1 | 21 September 2023 |
| | | US 11800733 B2 | 24 October 2023 |
| | | US 2020-0119296 A1 | 16 April 2020 |
| | | US 2023-0371297 A1 | 16 November 2023 |

Form PCT/ISA/210 (patent family annex) (July 2022)